(19) Europäisches Patentamt

European Patent Office

Office européen des brevets

(11) **EP 1 509 071 A1**

(12) **EUROPEAN PATENT APPLICATION**
published in accordance with Art. 158(3) EPC

(43) Date of publication:
**23.02.2005 Bulletin 2005/08**

(51) Int Cl.⁷: **H05K 3/46**, H05K 1/09,
H05K 1/11, H05K 3/40

(21) Application number: **03730552.1**

(22) Date of filing: **21.05.2003**

(86) International application number:
**PCT/JP2003/006362**

(87) International publication number:
**WO 2003/101166 (04.12.2003 Gazette 2003/49)**

(84) Designated Contracting States:
**DE FR GB**

(30) Priority: 28.05.2002 JP 2002154385
28.05.2002 JP 2002154386
21.06.2002 JP 2002180863
21.06.2002 JP 2002181342
26.11.2002 JP 2002341722

(71) Applicant: **SUMITOMO ELECTRIC INDUSTRIES, Ltd**
**Osaka-shi, Osaka 541-0041 (JP)**

(72) Inventors:
• **HIROSE, Yoshiyuki c/o Itami Works**
**Itami-shi, Hyogo 664-0016 (JP)**
• **TSUNO, Takashi c/o Itami Works**
**Itami-shi, Hyogo 664-0016 (JP)**

(74) Representative:
**Cross, Rupert Edward Blount et al**
**BOULT WADE TENNANT,**
**Verulam Gardens**
**70 Gray's Inn Road**
**London WC1X 8BT (GB)**

(54) **ALUMINUM NITRIDE SINTERED COMPACT HAVING METALLIZED LAYER AND METHOD FOR PREPARATION THEREOF**

(57)    It is an object to provide an aluminum nitride sintered body having a metallization layer, in which the bonding strength between the aluminum nitride and the metallization layer is high and there is no cracking within the metallization layer.

In the first aspect, a metallization layer is formed on a sheet of aluminum nitride by either coating the sheet with a paste containing a tungsten powder with an average particle size of 2 to 5 µm (used as a conductive high-melting point metal) or by making a through-hole in the sheet and filling this hole with this paste, and then sintering the whole thing at once. It is preferable here for no inorganic material powder other than tungsten to be admixed.

In the second aspect, in the manufacture of an aluminum nitride sintered body by coating a sheet of aluminum nitride with a paste containing a tungsten as a conductive high-melting point metal and then sintering the whole thing at once, the surface layer of the sintered body is ground or polished to remove at least one-fourth of the overall thickness after the co-firing.

In the third aspect, in the manufacture of an aluminum nitride sintered body by coating a sheet of aluminum nitride with a paste containing a tungsten as a conductive high-melting point metal and then sintering the whole thing at once, the planar shrinkage factor during the sintering of the sheet is adjusted to between 16.5 and 25 %. The planar shrinkage factor can be adjusted by employing two-stage mixing, in which just the powder and the solvent are mixed, and then the resin binder or a plasticizer is added, and controlling the mixing time of the powder and solvent.

In the fourth aspect, in the manufacture of an aluminum nitride sintered body by making a through-hole in a sheet of aluminum nitride, filling this through-hole with a paste containing a conductive high-melting point metal, a resin binder, and a solvent, and then sintering the whole thing at once, the amount of solvent in the paste is kept to no more than 0.5 to 5 weight parts per 100 weight parts metal powder.

EP 1 509 071 A1

## EP 1 509 071 A1

### Description

### TECHNICAL FIELD

This invention relates to an aluminum nitride sintered body having a metallization layer, which is useful as a substrate and package material for semiconductors and integrated circuits, and to a method for manufacturing this sintered body. Furthermore, it relates to an aluminum nitride sintered body that is used as a substrate or package after surface grinding or polishing, and to a method for manufacturing this sintered body, and more particularly to a method for manufacturing an aluminum nitride sintered body with which, when a via that is a metallized conductor for electrically connecting upper and lower surfaces is present in a substrate, and a conductive pattern is formed on both sides as needed, at least parts of the conductive patterns are electrically connected to each other by the via.

### BACKGROUND ART

Aluminum nitride sintered bodies have high thermal conductivity, which means that they radiate heat very well, and also have excellent electrical insulating properties and mechanical strength, which is why they are so often used as substrate and package materials on which semiconductors and integrated circuits with large power dissipation are mounted. When an aluminum nitride sintered body is used as a substrate or package, a metallization layer must be formed on the surface and/or in the interior of the aluminum nitride sintered body.

A metallization layer is usually formed by coating aluminum nitride by screen printer or the like with a paste made from molybdenum, tungsten, or other high-melting point metal, then sintering this product in a non-oxidative atmosphere of nitrogen or the like. This is generally referred to as a thick film method. With a thick film method, the paste coating and sintering may be performed on aluminum nitride that has already been sintered, or a green sheet of aluminum nitride that has yet to be sintered may be coated with paste, and the aluminum nitride and paste then sintered at the same time. A thin film method, in which the metallization layer is formed by sputtering or vapor deposition, can also be used. Compared to a thick film method, this affords greater patterning precision of the metallization layer, and since gold and other such metals can be used, an advantage is higher electrical conductivity.

Nevertheless, because aluminum nitride has poor wettability with metals, metallization is particularly difficult with a thick film method. In view of this, various adhesion-improving components have been investigated in an attempt to improve wettability and ensure good adhesive strength between an aluminum nitride sintered body and a metallization layer when metallization is performed.

The following is a list of conventional examples of increasing the bonding strength between an aluminum nitride sintered body's matrix and a metallization layer by using a metallization layer-forming material that contains an adhesion-improving component.

### Japanese Patent Publication No. H8-109084

Bonding strength is increased by using a metallization layer-forming material produced by adding an adhesion-improving component composed of one or more of titanium, zirconium, and hafnium and one or more of aluminum and rare earth elements to one or more metals selected from among molybdenum, tungsten, and tantalum.

### Japanese Patent Publication No. S63-115393

Bonding strength is increased by using a metallization layer-forming material produced by adding an adhesion-improving component which is obtained by mixing $SiO_2$, $Al_2O_3$, or CaO (the main component) as needed with one or more of MgO, BaO, and $B_2O_3$, to tungsten and/or molybdenum metal.

### Japanese Patent Publication No. S63-195183

Bonding strength is increased by using a metallization layer-forming material produced by adding an adhesion-improving component which is composed of one or more of CaO, BaO, SrO, $Y_2O_3$, $CeO_2$, and $Gd_2O_3$ and one or more of $Al_2O_3$ and AlN, to tungsten and/or molybdenum metal.

### Japanese Patent Publication No. H6-116068

Bonding strength is increased by laminating a first metallization layer containing one or more of molybdenum, tungsten, and tantalum with a second metallization layer, and including an adhesion-improving component containing at least $SiO_2$ or $Al_2O_3$ in the second metallization layer.

2

The above metallizations are most often formed by making a metal powder into a paste and applying it by screen printing or the like, but methods for ensuring good adhesive strength by controlling the particle size of the metal powder have also been investigated, and the following are examples of such techniques.

**Japanese Patent Publication No. S63-86598**

It is disclosed that the average particle size of tungsten and/or molybdenum is kept to no more than 3 µm, and preferably no more than 2 µm, the particles promotes reaction with aluminum nitride and yields a circuit substrate that is sufficiently bonded. This, however, is limited to a method in which the aluminum nitride is first sintered and then metallized.

**Japanese Patent Publication No. H4-83783**

Cracks are prevented from developing in the metallization layer by having a tungsten powder whose average particle size is from 1.0 to 1.5 µm contain from 3.0 to 10.0 wt% inorganic material having substantially the same composition as an aluminum nitride sintered body.

Furthermore, controlling the particle size of the metal powder offers other benefits besides that of increasing adhesive strength. For instance, it is stated in Japanese Patent Publication No. S63-206377 that metallization surface roughness can be reduced by using a paste in which one or more powders selected from the group consisting of single powders of molybdenum, tungsten, and elements from Group IV-A of the Periodic Table, and compound powders of these, is admixed while being pulverized so that the average particle size will be no more than 1.5 µm.

In addition, it is stated in Japanese Patent Publication No. S61-291480, for example, that bonding strength is increased by having the metallization layer composed of 100 weight parts of one or two materials selected from among tungsten, molybdenum, and borides and carbides of these, and 0.1 to 50 weight parts of aluminum nitride or the same components as an aluminum nitride base material. Furthermore, Japanese Patent Publication No. H4-83783 states that bonding strength is increased by having the metallization layer composed of a tungsten powder whose average particle size is 10 to 1.5 µm and which contains 3.0 to 10.0 wt% inorganic material having substantially the same composition as an aluminum nitride sintered body.

When these metallization techniques are employed, and especially with a thin film method, the substrate surface is sometimes ground or polished. This grinding or polishing of the substrate surface improves the adhesive strength between the thin-film metallization layer and the aluminum nitride substrate.

It has become increasingly important in recent years for metallization layers to have lower resistance, which has led to the need to increase the metallization layer thickness. Particularly when aluminum nitride having a metallization layer is used as a package or circuit substrate, the operating frequency of the semiconductors and integrated circuits mounted thereon is becoming higher, even greater than or equal to $1 \times 10^{10}$ Hz. Packages and circuit substrates need to carry high-frequency signals, and the conductor loss in a metallization layer poses a major problem in the transmission of these high-frequency signals. Accordingly, there has been an urgent need for a reduction in conductor loss, or put another way, for lower resistance.

A metallization layer is usually about 0.02 mm thick, but may be about 0.1 mm thick in some cases. Also, the use of aluminum nitride in packages has increased in recent years, and in such applications there is a great need for a multilayer wiring substrate structure, and a via (a metallization conductor) must be formed in a through-hole (via hole) in order to ensure interlayer conduction. Up to now, the via diameter has been 0.2 to 0.25 mm prior to sintering. After sintering, the diameter is generally 0.15 to 0.2 mm. However, it is also very important to lower the resistance of these vias, and lately it is not uncommon to require a via diameter of 0.3 to 0.45 mm, and 0.25 to 0.4 mm after sintering.

Unfortunately, while the measures adopted in the past did increase the bonding strength between a metallization layer and aluminum nitride, it was found that when the metallization layer becomes thicker, or when a metallization layer is filled in a through-hole, cracks may develop in the interior of the metal. Specifically, at about 0.02 mm, which is the thickness of ordinary metallization, bonding strength is high enough to pose no problem, and no cracking or the like occurs whatsoever inside the metallization layer, but if the thickness of the metallization layer is increased to about 0.1 mm, cracks develop inside the metallization layer, the strength of the metallization layer itself decreases, and in extreme cases the metallization layer can even break. The same problems are encountered when a metallization layer is filled in a through-hole. Metallization of a conventional through-hole diameter poses no problem, but problems do arise when the through-hole diameter prior to sintering increases to 0.3 mm, so the cause of the problems seems to be the same as when the metallization layer is made thicker.

Moreover, as grinding or polishing proceeds on a substrate surface in which there is at least one via (metallized conductor) that electrically connects the upper and lower surfaces, there is the problem of cracks forming in the via portion. The cause of this is believed to be the poor wettability of aluminum nitride by metals, and as discussed above, various adhesion-improving components have been investigated in the past in an effort to improve wettability and

## EP 1 509 071 A1

ensure good adhesive strength with the aluminum nitride after metallization. Such measures do minimize cracking to a certain extent in vias whose diameter after aluminum nitride sintering is about 0.15 to 0.2 mm. Unfortunately, a via diameter that is larger than usual (specifically, 0.25 to 0.4 mm after sintering) is often required in order to lower resistance, and in such a case these conventional measures have been found inadequate for preventing cracking.

Tungsten is used as the metal material for forming a metallization layer by co-firing with aluminum nitride, but the sintering temperature of aluminum nitride is quite high (about 2000°C), and is very different from the sintering temperature of tungsten, which is only about 1500°C. When materials with such widely differing sintering temperatures, such as a ceramic and a metal, are sintered at the same time, cracks tend to develop in the metallization layer, or the metallization layer tends to separate from the ceramic. These problems are particularly apt to occur in a conductor (via) formed in a through-hole (via hole) in order to ensure interlayer conduction in substrates and packages with multilayer structure.

A conventional approach to solving these problems has been to disperse the ceramic in the metal in an effort to bring the sintering temperatures of the ceramic and metal closer together. The above-mentioned Japanese Patent Publications No.s S61-291480 and H4-83783 discuss this technology.

With the methods that have been adopted up to now, though, a conductor (a metal) and an insulator (an adhesion-improving component) ended up being mixed in the metallization layer, therefore there was a limit to how much the resistance of the metallization layer could be reduced. While merely increasing the thickness of the metallization layer is fine for just reducing resistance, in addition to the problem of cracking, the resistivity per unit volume also need to be reduced in order to achieve a reduction in the conductor loss that accompanies the higher frequencies used today. And, there are applications that do not allow the use of a method in which the thickness of the metallization layer is increased.

### DISCLOSURE OF THE INVENTION

The present invention was conceived in light of this situation, and it is an object thereof to provide an aluminum nitride sintered body having a metallization layer, and a method for manufacturing the same, with which cracking within the metallization layer can be prevented even when the metallization layer is thick, and the bonding strength is high between the aluminum nitride and the metallization layer. It is another object of the present invention to provide an aluminum nitride sintered body having a metallization layer, and a method for manufacturing the same, with which resistivity per a unit volume of the metallization layer can be reduced, and at the same time the bonding strength between the metallization layer and the aluminum nitride sintered body can be increased. It is yet another object of the present invention to provide an aluminum nitride sintered body having a metallization layer, and a method for manufacturing the same, with which cracking within the metallization layer can be prevented even when the metallization layer is thick and also the via diameter is large, and the bonding strength is high between the aluminum nitride and the metallization layer. It is a further object of the present invention to provide a method for manufacturing an aluminum nitride substrate whose surface is ground or polished, with which via cracking that occurs after the grinding or polishing of the aluminum nitride substrate surface can be prevented even when the via diameter is large.

The present invention will now be described in detail, touching upon the common constitution and various aspects thereof.

1 Matrix

The aluminum nitride sintered body's matrix that constitutes the aluminum nitride sintered body having a metallization layer of the present invention is obtained by forming a sintering powder whose main component is an aluminum nitride powder and to which a powder of a compound of yttrium, a rare earth metal, an alkali metal, an alkaline earth metal, or the like known as sintering additives is added in an amount of about 0.1 to 10 wt%, and then sintering.

The forming method is as follows. A resin binder such as polyvinyl butyral (PVB) and a plasticizer such as dibutyl phthalate are mixed with an aluminum nitride powder and a sintering additive powder, and this mixture is granulated, after which molding may be performed with a press or the like, or a green sheet may be produced by doctor blade process after mixing. Extrusion and other such methods can also be applied.

To form a multilayer structure, however, it is necessary to laminate the aluminum nitride and the metallization layer prior to sintering, and then sintered body them at the same time. This is difficult with press molding, so the use of a green sheet is more common. Also, forming through-holes and vias is difficult with press molding, so typically a green sheet will be used and the components sintered at the same time.

A punch or the like can be used to form a through-hole in a green sheet if needed. This through-hole is filled with a paste having the composition described below. This filling can be accomplished by screen printing or another such known method. If needed, circuit wiring or the like can also be formed by coating with a paste having the composition described below. Any known coating method can be employed, such as screen printing, brush coating, or spin roller coating.

2 Paste for forming the metallization layer

The paste used in the present invention to form a via or circuit wiring is composed mainly of a conductive high-melting point metal powder, a resin binder, and a solvent. A tungsten powder is used as the conductive high-melting point metal powder in the present invention. A green sheet composed of aluminum nitride needs to be sintered at the same time as the composition used to form the metallization layer, and the use of tungsten as the conductor powder is preferable because the sintering temperatures of the aluminum nitride powder and the tungsten powder will be closer together and their coefficients of thermal expansion will also be similar.

A paste is obtained by dispersing these powders in a solvent such as butylcarbitol, butylcarbitol acetate, or terpineol along with a resin binder such as ethyl cellulose, nitrocellulose, or an acrylic resin. The resin binder is usually used in an amount of 1 to 3 weight parts per 100 weight parts of tungsten powder or other powder. The solvent content is usually no more than 20 weight parts, and most often about 1 to 15 weight parts, although the amount will vary the aspect of the invention as discussed below. Mixing can be accomplished by a method in which just the powder and the solvent are first mixed in a pot mill, ball mill, mixer/grinder, or the like, after which the resin binder is mixed in using a triple roll mill or the like.

3 Sintering method

The above-mentioned paste is filled into a through-hole in a green sheet of aluminum nitride, or a circuit is printed with the paste, after which a green sheet is laminated as needed. This lamination involves placing the sheet in a mold, and applying pressure of about 5 to 10 MPa for about 10 to 20 minutes in a press while heating to about 50 to 80°C to achieve thermocompression bonding. A solvent or adhesive agent may be applied as needed between the sheets.

The laminated sheet is cut to the desired shape and then sintered. Prior to sintering, the sheet may be degreased for example at 300 to 800 °C, in order to remove the resin binder and plasticizer from the aluminum nitride green sheet and the paste.

The sintering is carried out in a non-oxidative atmosphere, and preferably in a nitrogen atmosphere. The sintering temperature and time are set so as to achieve the desired characteristics such as thermal conductivity in the aluminum nitride sintered body. Generally, the sintering temperature is set to between 1600 and 2000 °C, and the sintering time to about 1 to 5 hours.

4 First aspect of the present invention

The first aspect of the present invention provides an aluminum nitride sintered body having a metallization layer on its surface and/or in its interior, wherein the metallization layer is composed primarily of a conductive high-melting point metal, the conductive high-melting point metal is tungsten, and an average particle size of the tungsten is 2 to 5.5 $\mu$m; or

A method for manufacturing an aluminum nitride sintered body having a metallization layer by coating a ceramic green sheet whose main component is aluminum nitride with a paste mainly containing a conductive high-melting point metal, and then sintering the whole thing at once, wherein the conductive high-melting point metal contained in the paste is a tungsten powder with an average particle size of 2 to 5 $\mu$m; or

A method for manufacturing an aluminum nitride sintered body having a metallization layer by making a through-hole in a ceramic green sheet whose main component is aluminum nitride, filling said through-hole with a paste mainly containing a conductive high-melting point metal, and then sintering the whole thing at once, wherein the conductive high-melting point metal contained in the paste is a tungsten powder with an average particle size of 2 to 5 $\mu$m.

In the present invention, a conductive high-melting point metal powder in which the average particle size of the tungsten powder is 2 to 5 $\mu$m is used to form the metallization layer. A plurality of tungsten powders with different average particle sizes are often used as a mixture, in which case it is preferable to use at least 50 wt% tungsten having an average particle size of 2 to 5 $\mu$m. If the average particle size of the tungsten powder is less than 2 $\mu$m, the sintering commencement temperature of the tungsten will be considerably lower than the sintering temperature of the aluminum nitride. A tungsten powder having an average particle size of about 1 to 1.5 $\mu$m is generally used, and the sintering commencement temperature of tungsten having an average particle size such as this is lower than the sintering temperature of the aluminum nitride. For example, if we assume that aluminum nitride will be sintered at 1800 to 1900 °C, the sintering of the aluminum nitride will commence at 1700 to 1800 °C, whereas the sintering of the tungsten will commence at 1300 to 1500 °C. The particle size of the powders is measured using a laser diffraction particle size analyzer. The particle size of the sintered bodies discussed below was calculated by imaging electron micrographs

EP 1 509 071 A1

(1000 power) of fracture surfaces.

When the sintering commencement temperatures of the aluminum nitride and tungsten are so greatly different, with a paste filled into a through-hole, for example, the paste portion will begin to shrink before the sintering of the aluminum nitride matrix commences, that is, before shrinkage commences. Accordingly, cracks tend to develop in portions of weak bonding around the periphery of the through-hole. For instance, if there is a heterogeneous portion in the paste filled into the through-hole, cracks will develop inside the via, and if there are any defects in the aluminum nitride matrix, then cracks will develop in the matrix. If there are no defects in either the via or the aluminum nitride, cracks will develop at the interface between the matrix and the via. The particle size of the tungsten powder must be at least 2 μm in order to avoid these cracks.

With a tungsten powder of small particle size, when the paste is filled into the through-hole, since a smaller particle size of the tungsten powder means that the bulk density is lower, the filling density of the tungsten powder in the paste will also be lower. Shrinkage during sintering will be extremely high in this case, and will therefore be very different from the shrinkage of the aluminum nitride matrix, making the via more susceptible to cracking. Furthermore, agglomeration is inevitable if the tungsten particle size is small, so the tungsten cannot be filled uniformly in the via, and once again cracks are apt to occur. In specific terms, if the average particle size of the tungsten powder is less than 1 μm, the tungsten filling density will be extremely low, and cracking within the via will be inevitable.

On the other hand, if the average particle size of the tungsten powder is greater than 5 μm, sinterability of the tungsten powder will be markedly worse, and the tungsten powder will not be sufficiently sintered at the sintering temperature of the aluminum nitride. While no cracking occurs in this case, the bonding strength is low, and the bonding strength between the metallization layer and the aluminum nitride is extremely weak, making practical application difficult. Also, since the via portion is not sintered, the product will be incompatible with applications that require hermetic sealing.

When a tungsten powder whose average particle size is 2 to 5 pm is used, the average particle size after sintering will similarly be 2 to 5.5 μm. In general, a powder undergoes particle growth when sintered, so the average particle size after sintering is ordinarily larger than the average particle size of the powder. However, tungsten is a material that is difficult to sinter, and does not undergo much sintering at the sintering temperature and in the sintering atmosphere of aluminum nitride, such as in nitrogen. Although some of the particles of the tungsten powder are joined, the structure is not one in which overall particles have grown. Consequently, the average particle size remains about the same as before sintering. This structure is most pronounced in the interior of the sintered body. As to the tungsten formed on the sintered body's surface, there is a certain amount of particle growth in the structure, and the particles are closely joined, but the particle size is not that different from that inside the sintered body.

It is stated in the above-mentioned Japanese Patent Publication No. S63-86598 that the average particle size of tungsten and/or molybdenum is kept to no more than 3 μm, and preferably no more than 2 μm, which promotes reaction with aluminum nitride and yields a circuit substrate that is sufficiently bonded. The present invention, in which a powder having a tungsten average particle size of 2 to 5 μm is utilized, seems at first glance to be technologically the same as the invention described in the above-mentioned Japanese Patent Publication No. S63-86598.

However, the invention described in Japanese Patent Publication No. S63-86598 is limited to a method in which metallization is performed after the aluminum nitride has already been sintered (post-metallization). In contrast, the present invention focuses on co-firing, in which the aluminum nitride and tungsten are sintered at the same time. Since a sintered aluminum nitride substrate is used in post-metallization, all that needs to be considered is the sintering of tungsten. Also, there is no need for the high temperature of 1800 to 1900 °C at which aluminum nitride is sintered, and instead the sintering is generally performed at a relatively low temperature of about 1500 to 1700 °C. One reason for sintering at a lower temperature is that raising the temperature to between 1800 and 1900 °C adversely affects the aluminum nitride substrate serving as the matrix. Thus, when only tungsten is being sintered, and furthermore at a lower temperature, there is no need to worry about cracking of the metallization layer that would otherwise result from mismatched sintering commencement temperatures of the tungsten and matrix as with co-firing Specifically, the technological key points in post-metallization are completely different from those in co-firing and the present invention, which aims to eliminate the cracking of the metallization layer, as well as the decrease in adhesive strength between the metallization layer and the matrix that accompanies this cracking, is fundamentally different from the invention described in the above-mentioned Japanese Patent Publication No. S63-86598.

The average particle size of the tungsten powder is even more preferably 2.5 to 4 μm. A plurality of tungsten powders with different average particle sizes are often used as a mixture, in which case it is preferable to use at least 50 wt% tungsten having an average particle size of 2.5 to 4 μm. A tungsten powder generally has a somewhat broad particle size distribution with respect to average particle size. This spread in the particle size distribution may vary somewhat with the powder lot. Usually, the range is about 1 to 2 μm on either side of the average particle size, but in some cases this range can be as much as about 2 to 3 μm. In these cases, if the average particle size of the tungsten powder is less than 2.5 μm, a large particle size distribution can lead to cracking in the metallization layer, with the cracks starting at smaller tungsten powder within the distribution. This is because sintering, that is, shrinkage, of smaller tungsten powder within the distribution commences at a low temperature even though the average particle size is at least 2 μm.

On the other hand, if the average particle size of the tungsten powder is greater than 4 μm, a large particle size distribution can cause larger powder within the distribution to remain unsintered even though the average particle size is no greater than 5 μm. To avoid these situations, it is preferable for the average particle size of the tungsten powder to be between 2.5 and 4 μm. When a tungsten powder with this average particle size is used, the average particle size after sintering will be 2.5 to 4.5 μm.

As discussed above, the aluminum nitride sintered body having a metallization layer of the present invention will not undergo any cracking in the metallization layer even if the metallization layer is thick, so an aluminum nitride sintered body having a metallization layer can be obtained with high bonding strength between the metallization layer and the aluminum nitride sintered body.

In a preferred aspect of the present invention, the inorganic material normally used in a paste for forming a metallization layer is not admixed.

The metallization of aluminum nitride has been considered difficult up to now because of its poor wettability with metals. In view of this, mixing an inorganic material as an adhesion-improving component into a paste has been investigated in an attempt to improve wettability and ensure good adhesive strength with the aluminum nitride after metallization. This inorganic material is usually added in an amount of at least 10 wt%. In terms of volume, this accounts for 30 to 50 vol%, which has greatly hindered attempts at lowering the resistivity per unit of volume of a metallization layer.

To achieve the reduction in the resistivity of metallization layers that has recently become so important, it was considered desirable to metallize aluminum nitride without adding any inorganic material, and the inventors took a fresh look at the joining mechanism of the aluminum nitride and metal. As a result, they found that aluminum nitride and a metal are joined by a mechanism involving the interposition of an adhesion-improving component, and by an interlocking mechanism in which the aluminum nitride particles and tungsten particles are mechanically interlocked. They also found that the interlocking mechanism between particles plays a major role in the joining strength of aluminum nitride and a metal. Specifically, they found that it is basically possible for aluminum nitride and a metal to be joined even if no inorganic material (adhesion-improving component) is admixed.

However, to produce metallization with adequate strength without using an adhesion-improving component, the particle size of the tungsten mixed into the paste and the condition of the paste must be strictly controlled. This is described in detail below, mainly by examining a method in which metallization is produced by co-firing after a paste has been filled into a through-hole provided in a green sheet.

Experiments in which through-holes were filled with various tungsten pastes were carried out repeatedly, and as a result it was found that for a metallization layer to be joined with adequate strength to aluminum nitride without using any adhesion-improving component, the particle size of the tungsten at least after sintering needs to be roughly the same as the aluminum nitride particle size. This alone, however, was not enough to prevent the frequent occurrence of decreased joining strength and cracking in the metallization layer or aluminum nitride, so the yield could not be increased. The cause of these problems was sought, and as a result, the most significant cause was concluded to be that, as discussed above, there is a major difference between the sintering commencement temperatures (that is, the shrinkage commencement temperatures) of the aluminum nitride matrix and the metallization layer portion. If the sintering commencement temperatures of the aluminum nitride and tungsten are too far apart, as mentioned above, cracks develop in the via or matrix, and the occurrence of these cracks is directly linked to a drop in joining strength.

Similarly, if we consider a printed metallization layer, cracks tend to occur around the periphery of the metallization layer, and this causes a drop in joining strength. To avoid these cracks and the decrease in joining strength that accompanies cracking, the sintering commencement temperatures of the aluminum nitride and tungsten paste portion must be closer together. Basically, the sintering temperature of the tungsten needs to be raised to bring it closer to the sintering commencement temperature of the aluminum nitride, and it is necessary to use a tungsten powder with a coarser particle size than that generally used. To this end, a tungsten powder whose average particle size is 2 to 5 μm is used. When a plurality of tungsten powders with different tungsten particle sizes are used as a mixture, it is preferable to use at least 50 wt% tungsten having an average particle size of 2 to 5 μm.

If the sintering commencement temperatures are too far apart, as mentioned above, cracks will develop either inside the via, in the aluminum nitride matrix, or at the interface between the matrix and the via, or in all of these, but the smaller is the particle size of the tungsten powder, the more distinctive are the cracks formed in the aluminum nitride matrix. At the sintering commencement temperature of a tungsten powder with a fine particle size, the resin binder is burned off with an aluminum nitride matrix, but the aluminum nitride particles do not undergo particle growth or neck growth, and an extremely brittle state results. Consequently, it is believed that cracks readily develop under the stress resulting from the commencement of shrinkage of the tungsten portion. The cracks produced here are distinctive in that they form in a crescent shape around the via.

The average particle size of the aluminum nitride after sintering is generally 2 to 5 μm, which is equivalent to the particle size of the tungsten if the average particle size of the tungsten powder prior to sintering is similarly 2 to 5 μm. Accordingly, a strong interlocking effect can be obtained between the aluminum nitride particles and tungsten particles.

Also, even if no inorganic material powder is used, particularly when a pot mill, ball mill, or mixer/grinder is used, the admixture of inorganic materials from these machines cannot be completely avoided. For instance, with a pot mill, the balls contained inside as the media are made of an inorganic material, generally alumina, and with a ball mill, the inner part between the balls and the pot is made of an inorganic material. With a mixer/grinder, the mortar and mixing rod are made of an inorganic material. These mixing machines work by imparting shear force to a powder or solvent through the collision and rubbing together of inorganic materials, and the inorganic materials themselves are abraded in the course of this collision and rubbing, and are gradually admixed into the paste.

Alumina is commonly used as this inorganic material, and even though it is not intentionally admixed as a powder, the admixture of alumina or other inorganic material is unavoidable. The amount of admixture will vary with the mixing machine being used and the mixing time, but is generally 1 wt% or less. Accordingly, analysis of the metallization layer of the aluminum nitride after sintering will inevitably turn up inorganic material in an amount of 1 wt% or less, but this does not compromise the effect of the present invention.

Next, the manufactured paste is filled into a through-hole in a green sheet of aluminum nitride. Cracks and the decrease in joining strength that accompanies cracking can be avoided by keeping the filling ratio of the tungsten powder inside the through-hole between 30 and 70%. The filling ratio of tungsten powder can be found from the weight change before and after the tungsten paste is filled into the through-hole, and the total volume of the through-hole. A high filling ratio results in a small shrinkage factor during sintering, while a low filling ratio results in a large shrinkage factor. The filling ratio of tungsten is equivalent to the relative density of the green sheet (the relative value of the green density of the green sheet versus the sintered density of the aluminum nitride), which is expressed as follows.

$$\text{Relative density of green sheet} = (\text{green density of}$$

$$\text{green sheet/density of aluminum nitride after sintering}) \times$$

$$100\ (\%)$$

The relative density of a green sheet is generally around 60 %, and basically the shrinkage factors of the two materials should move closer together when the filling ratio of the tungsten powder is also closer to 60 %, and this is believed to allow cracking and so forth to be avoided. Unfortunately, other factors need to be taken into account in actual practice. Specifically, the tungsten powder filled into the through-hole shrinks uniformly in both the planar and the thickness direction during sintering, whereas the green sheet has residual stress from the production of the sheet with a doctor blade or the like, so its shrinkage is different in the planar and thickness directions, with the shrinkage being greater in the thickness direction than in the planar direction. Furthermore, the shrinkage factor differs even in the planar direction. Also, since tungsten does not sinter completely compactly at the sintering temperature of aluminum nitride, the density after sintering is lower than that of pure tungsten. The optimal filling ratio of tungsten must be determined while taking into account these factors.

Actual experiments have revealed that if the filling ratio of tungsten powder is less than 30 %, the shrinkage factor during sintering of the tungsten portion will be too high, so cracks in the via cannot be avoided. On the other hand, if the filling ratio of tungsten powder is greater than 70 %, the shrinkage factor of the via will be lower than that of the aluminum nitride matrix, so cracks will develop in the aluminum nitride matrix. A characteristic of these cracks is that they radiate out from the via.

The filling ratio of the tungsten powder inside the through-hole is preferably 40 to 50 %. Although there will be no cracks in the via if the filling ratio is less than 40 %, the surface of the through-hole may sink, which is caused by the shrinkage factor of tungsten being greater than that of aluminum nitride. Accordingly, when the sheet has a laminated structure as discussed below, conduction between the upper and lower surfaces will be ensured by the through-hole, but the contact surface area will decrease due to the sinkage of the via surface. This is accompanied by an increase in contact resistance, which hampers efforts at lowering the resistance of the metallization layer.

On the other hand, although there will be no cracks in the via if the filling ratio is over 50 %, the via will be kind of stretched in the thickness direction, and will protrude from the upper and lower surfaces. A filling ratio of 50 % is less than the 60 % that is the relative density of the green sheet of aluminum nitride, the cause of which is believed to be that the shrinkage factor in the thickness direction is lower than that of aluminum nitride, which can be attributed to the above-mentioned anisotropy of the shrinkage factor in the green sheet and to the fact that tungsten does not completely sinter at the sintering temperature of aluminum nitride. This protrusion of the via poses a problem not only in terms of appearance, but also because when other metal parts are joined to the metallization layer by a method such as soldering, there is the possibility that the solder will not flow properly. Keeping the filling ratio between 40 and 50 % allows a good via to be formed, but further experimentation on the part of the inventors has revealed that the work will be easier if the filling ratio is between 45 and 50 %. This is because sinkage of the via is seen very infrequently when the filling ratio is between 40 and 45 %. Still, the probability of via sinkage occurring when the filling ratio is between 40 and 45 % is not greater than 0.1 %.

The viscosity of the tungsten paste is of the utmost importance in terms of achieving the desired tungsten powder filling ratio. In general, the smaller is the solvent content in the paste, the higher is the viscosity, and filling a through-hole with a high-viscosity paste means that less of the solvent will volatilize after filling, which affords a higher filling ratio. Accordingly, it is preferable for the viscosity of the tungsten paste to be between 10,000 and 1,000,000 P. Incidentally, the viscosity value will vary slightly from one measurement device to another, but the viscosity values given here were obtained using a 5× HBDV-I+ made by Brookfield.

If the viscosity is less than 10,000 P, the filling ratio of the tungsten powder cannot be raised to at least 30 %, so cracks will be unavoidable. On the other hand, if the viscosity is over 1,000,000 P, the filling ratio of tungsten powder will exceed 70 %, so cracks in the aluminum nitride will be unavoidable.

The viscosity of the tungsten paste is preferably 30,000 to 500,000 P. If the viscosity is less than 30,000 P, the filling ratio of tungsten powder will be under 40 %, so sinkage will occur on the via surface. Furthermore, certain printing and drying conditions will result in cracks in the via. On the other hand, if the viscosity is over 500,000 P, the filling ratio of tungsten powder will be greater than 50 %, so via protrusion will occur. Furthermore, the paste will be extremely hard, so under certain printing conditions it will be impossible to completely fill the tungsten paste into the through-hole by printing.

As discussed above, the aluminum nitride substrate having a metallization layer of the present invention affords a reduction in the resistivity per unit volume of the metallization layer, while preventing cracking within the metallization layer, and at the same time affords greater joining strength with aluminum nitride.

Also, even if the co-firing method featuring a green sheet that has been the focus of discussion up to this point is not used, if, for example, just the aluminum nitride substrate is first sintered, and then the substrate is coated with a paste that will produce the metallization layer of the present invention, and sintered in a non-oxidative atmosphere at 1600 to 2000 °C, the result will be an the aluminum nitride substrate having a metallization layer that affords a reduction in the resistivity per unit volume of the metallization layer, while preventing cracking within the metallization layer, and at the same time affords greater joining strength with aluminum nitride. With this method, though, it is difficult to obtain an aluminum nitride sintered body having a multilayer structure, a through-hole, or a via.

5 Second aspect of the present invention

The second aspect of the present invention provides A method for manufacturing an aluminum nitride sintered body having a metallization layer by coating a ceramic green sheet whose main component is aluminum nitride with a paste containing a conductive high-melting point metal, and then sintering the whole thing at once, wherein the conductive high-melting point metal contained in the paste is tungsten, and a planar shrinkage factor when the ceramic green sheet is sintered is at least 16.5 and no more than 25 %; or

A method for manufacturing an aluminum nitride sintered body having a metallization layer by making a through-hole in a ceramic green sheet whose main component is aluminum nitride, filling said through-hole with a paste containing a conductive high-melting point metal, and then sintering the whole thing at once, wherein the conductive high-melting point metal contained in the paste is tungsten, and a planar shrinkage factor when the ceramic green sheet is sintered is 16.5 to 25 %.

In order to increase adhesive strength between aluminum nitride and metals, as discussed above, the mixing of an inorganic material as an adhesion-improving component into a paste has been investigated in an attempt to improve wettability between aluminum nitride and metals and ensure good adhesive strength between metallized aluminum nitride. In contrast to this, the inventors reviewed the joining mechanism between aluminum nitride and metals, and as a result found that aluminum nitride and a metal are joined by a mechanism involving the interposition of an adhesion-improving component, and by an interlocking mechanism in which the aluminum nitride particles and tungsten particles are mechanically interlocked. They also found that the interlocking mechanism between particles plays a major role in the joining strength of aluminum nitride and a metal. Specifically, they found that to eliminate the cracking of the metallization layer that accompanies an increase in through-hole diameter, what is most important is not the addition of an adhesion-improving inorganic material, but actually the effective functioning of the joining mechanism involving interlock.

To make the above-mentioned interlocking joining mechanism function effectively, the state of the green sheet and paste must be strictly controlled, and we will now describe this in detail, primarily using as an example a method in which a paste is filled into a through-hole provided in a green sheet, after which everything is sintered at the same time to effect metallization.

Experiments in which through-holes were filled with various tungsten pastes were carried out repeatedly, and as a result it was found that for a joining mechanism involving interlock to function effectively, the shrinkage factor of the green sheet in the sintering of the aluminum nitride must be brought closer to the shrinkage factor of the tungsten paste filled into the through-hole. If there is too much difference between the two shrinkage factors, then when the shrinkage factor of the green sheet is less than the shrinkage factor of the tungsten paste filled into the through-hole, for example, the tungsten paste will shrink more, and cracks will develop in the tungsten paste and around its periphery. On the other hand, when the shrinkage factor of the green sheet is greater, the green sheet will shrink more, so the tungsten paste portion will be stretched and cracks will develop in the green sheet.

This shrinkage factor is closely related to the relative density of the green sheet and the filling ratio of the tungsten paste. The relative density of a green sheet is generally expressed by the following formula, and is usually somewhere around 60 %.

Relative density of green sheet (%) =

(green density of green sheet/density after sintering) $\times$ 100

The filling ratio corresponding to the relative density of tungsten filled into the through-hole is about 30 to 50 %. Basically, the shrinkage factors of the two materials should move closer together when the filling ratio of the tungsten powder is also closer to 60 %, and this is believed to allow cracking and so forth to be avoided. Unfortunately, other factors must be taken into account in actual practice. Specifically, the tungsten powder filled into the through-hole shrinks uniformly in both the planar and the thickness direction during sintering, whereas the green sheet has residual stress from the production of the sheet with a doctor blade or the like, so its shrinkage is different in the planar and thickness directions, with the shrinkage being greater in the thickness direction than in the planar direction. Furthermore, the shrinkage factor differs even in the planar direction. Also, since tungsten does not sinter completely compactly at the sintering temperature of aluminum nitride, the density after sintering is lower than that of pure tungsten.

These factors are considered so that the filling ratio of tungsten paste in the through-hole is increased and the shrinkage factor during sintering is brought closer to that of the aluminum nitride matrix, but on the other hand, there is an upper limit to the shrinkage factor of the tungsten paste in the through-hole. When the tungsten paste is filled by screen printing, possible ways of increasing the filling ratio include raising the viscosity of the paste, or raising the pressure applied in the injection of the paste by printing (printing pressure). With a method in which the paste viscosity is raised, if the viscosity is made too high it will be difficult to produce the paste, so there is an upper limit to the viscosity. Specifically, during paste production the tungsten powder must be mixed with a solvent and so forth, and mixing is performed using a triple roll mill or the like, but because the paste viscosity becomes too high, the paste is unable to pass through the triple roll mill.

Similarly, with a method in which the printing pressure is raised, there is an upper limit to the printing pressure. This is because printing pressure is also applied to the green sheet, which is what is being printed, but if the printing pressure is too high, the green sheet will be deformed.

Also, raising the paste viscosity and raising the printing pressure both tend to impair productivity. When the paste viscosity is raised, the fluidity of the paste in the through-hole suffers, so printing takes a long time when an attempt is made to fill the hole completely full, meanwhile, if the printing pressure is higher, this markedly shortens the service life of the scraper of the screen printing machine used to press in the paste. Consequently, when productivity is taken into account, the limit to the filling ratio of the tungsten filled into the through-hole is about 50 %.

It is thus possible to prevent cracking by setting the tungsten filling ratio to 50 %, but the paste and screen printing machine need to be properly managed and controlled as discussed above. However, despite this control, sporadic defects could not be avoided. Ways to prevent these sporadic defects were studied, and as a result the inventors concluded that controlling the shrinkage factor of the aluminum nitride matrix is effective. Sporadic defects were successfully prevented by bringing the shrinkage factor of the aluminum nitride matrix closer to the shrinkage factor of the tungsten in the through-hole.

The following are possible methods for lowering the relative density of a green sheet.

① Lowering the bulk density of the raw material powder.
② Using a green sheet composed of a raw material powder, sintering additive, resin binder, and plasticizer, and varying the mix ratio of these components.
③ As a preliminary stage in which a green sheet is produced with a doctor blade, mixing a raw material powder, sintering additive, resin binder, and plasticizer with a solvent in a ball mill or the like, and varying the mixing time.

The above method ① requires that the raw material powder be changed, and it is quite likely that the process conditions including the sintering conditions will be greatly changed, making this method undesirable. The above method ② also requires that the mixed amount of resin binder or plasticizer be changed, and this is accompanied by changes in the process conditions, although not to the same extent as in method ① , again making this method undesirable. Meanwhile, the above method ③ is the most favorable because the relative density of the green sheet can be changed merely by optimizing the mixing time.

The reason the relative density can be varied with the above method ③ is as follows. The raw material powder usually contains a large amount of agglomerated particles, and these agglomerated particles do not readily separate under mixing in a ball mill or the like. There is more of this separation the longer is the mixing time. On the other hand, if a green sheet is produced in a state in which a large quantity of agglomerated particles are present, the resulting green sheet will have a low relative density because the agglomerated particles put together a rough bridge. Consequently, a longer ball mill mixing time will yield a green sheet with a higher relative density. Mixing the powder with just a solvent is more effective at separating these agglomerated particles than also mixing in a resin binder or plasticizer. Accordingly, the most efficient way to vary the relative density of a green sheet is to adjust the mixing time of the powder and solvent by employing a two-stage mixing process in which first just the powder and solvent are mixed, and then a resin binder or plasticizer is added.

Green sheets having various relative densities were produced in this manner and the metallization layer of the through-hole was examined for cracks, and as a result it was found that to obtain a metallization layer free of cracks, the shrinkage factor in the planar direction during sintering of the aluminum nitride green sheet needs to be between 16.5 and 25 %. The planar shrinkage factor is expressed by the following formula.

$$\text{Planar shrinkage factor (\%)} =$$

$$\text{(planar dimensions before sintering - planar dimensions after}$$

$$\text{sintering)/planar dimensions before sintering} \times 100$$

As discussed above, the shrinkage factor is closely related to the relative density of the green sheet. Nevertheless, when the amounts of resin binder and plasticizer contained in the green sheet vary, the shrinkage factor will be different at a given green sheet relative density. Accordingly, it is impossible to definitively specify the relative density of a green sheet for obtaining the above-mentioned planar shrinkage factor.

If the planar shrinkage factor during the sintering of the green sheet is less than 16.5 %, then the tungsten shrinkage factor cannot be kept sufficiently low even if the tungsten filling ratio in the through-hole is raised to 50 %, so cracking cannot be eliminated from the metallization layer of the through-hole after aluminum nitride sintering. On the other hand, if the planar shrinkage factor during the sintering of the green sheet is over 25 %, the shrinkage factor of the green sheet will be too large, and the tungsten in the through-hole will be stretched during the sintering of the aluminum nitride, so cracks will develop in the aluminum nitride matrix.

A characteristic of these cracks is that they radiate out from the through-hole, and when the shrinkage factor of the green sheet is greater than 25 %, these cracks can be avoided by lowering the tungsten filling ratio in the through-hole to about 20 %. However, lowering the tungsten filling ratio to about 20 % makes it difficult to fill the tungsten uniformly in the through-hole, making it inevitable that the unevenness of the tungsten distribution during sintering will lead to cracking, or that cracks will develop immediately after filling prior to sintering due to the insertion of bubbles. Consequently, if the shrinkage factor of the green sheet is greater than 25 %, a sintered body free of cracks cannot be obtained from either aluminum nitride or tungsten.

It is even better for the planar shrinkage factor during sintering of the green sheet to be from 18 to 23 %. If, as discussed above, the planar shrinkage factor is at least 16.5 and less than 18 %, cracks in the metal layer of the through-hole can be eliminated by raising the tungsten filling ratio in the through-hole to about 50 %. However, to raise the tungsten filling ratio in the through-hole to 50 %, it is essential to have some way of raising the viscosity of the tungsten paste, raising the pressure during the filling of the paste, or the like. These measures, however, tend to impair productivity, and therefore are best not used. When these measures are not used, the tungsten filling ratio in the through-hole is generally about 40 %. Furthermore, even if these measures are implemented, the filling ratio of the paste may not be stable, and the filling ratio may sporadically drop to about 40 %. Therefore, to prevent cracking of the metal layer in the through-hole even at this tungsten filling ratio, it is preferable for the planar shrinkage factor of the green sheet to be at least 18 %.

On the other hand, to obtain a through-hole metal layer that is free of cracks as discussed above, the planar shrinkage factor must be kept to 25 % or less. However, at no more than 25 % and greater than 23 %, as discussed above, if the tungsten filling ratio in the through-hole is not lowered to close to 20 %, the aluminum nitride will be susceptible to cracking. At such a low tungsten filling ratio, however, as discussed above, the tungsten distribution tends to be uneven or occur bubbles insertion and so on, and problems tend to occur unless the tungsten paste and the paste filling conditions are not strictly controlled. In contrast, if the planar shrinkage factor of the green sheet is kept to 23 % or less, the tungsten filling ratio in the through-hole can be raised to about 40 %, which is the normal filling ratio, so even without strictly controlling the tungsten paste and the paste filling conditions, cracks in the metal layer of the through-hole attributable to the unevenness of the tungsten distribution, the insertion of bubbles, and so forth can be prevented.

Preferably, the planar shrinkage factor during the sintering of the green sheet is 20 to 23 %. If the tungsten filling ratio in the through-hole is about 40 % as discussed above, the planar shrinkage factor need only be at least 18%, but if the condition or the filling conditions of the tungsten paste should change, then the tungsten filling ratio may sporadically drop to about 35 % even though the process has been designed at a tungsten filling ratio of 40 %. Here again, to prevent cracks in the metal layer of the through-hole, the planar shrinkage factor of the green sheet should be at least 20 %.

The tungsten powder used to manufacture the tungsten paste should have an average particle size of 2 to 5 $\mu$m so that the sintering temperatures of the aluminum nitride and tungsten will be closer together. A mixture of a plurality of tungsten particle sizes is often used, in which case it is preferable to use at least 50 wt% tungsten having an average particle size of 2 to 5 $\mu$m. If the average particle size of the tungsten powder is less than 2 $\mu$m, the sintering commencement temperature of the tungsten will be considerably lower than the sintering temperature of the aluminum nitride, so cracks will tend to develop in the tungsten or at the interface between tungsten and the aluminum nitride. On the other hand, it is also undesirable for the average particle size of the tungsten powder to be larger than 5 $\mu$m, because the sinterability of the tungsten will be markedly worse and the tungsten will not be sufficiently sintered at the sintering temperature of the aluminum nitride.

As discussed above, the aluminum nitride substrate having a metallization layer of the present invention prevents cracks in the metallization layer even when the metallization layer is thick, and also allows the joining strength between the aluminum nitride and metallization layer to be increased.

6 Third aspect of the present invention

The third aspect of the present invention provides a method for manufacturing an aluminum nitride sintered body substrate which is used as a substrate after surface grinding or polishing and has at least one via that is a metallized conductor for electrically connecting upper and lower surfaces, wherein a through-hole is made in a ceramic green sheet whose main component is aluminum nitride, said through-hole is filled with a paste containing a conductive high-melting point metal, the entire single-layer green sheet thus obtained is sintered all at once without being laminated, thereby obtaining an aluminum nitride sintered body, and the surface of this aluminum nitride sintered body is then ground or polished so as to remove at least one-fourth of a thickness of said aluminum nitride sintered body; or

a method for manufacturing an aluminum nitride sintered body substrate which is used as a substrate after surface grinding or polishing and has at least one via that is a metallized conductor for electrically connecting upper and lower surfaces, wherein a through-hole is made in a ceramic green sheet whose main component is aluminum nitride, said through-hole is filled with a paste containing a conductive high-melting point metal, a plurality of the entire single-layer green sheets thus obtained are laminated and sintered all at once, thereby obtaining an aluminum nitride sintered body, and the surface of this aluminum nitride sintered body is then ground or polished to remove at least one-eighth of a thickness equal to twice a thickness of an outermost layer of the layers constituting said aluminum nitride sintered body.

The aluminum nitride sintered body obtained as discussed above by forming a hole in a green sheet, filling this with a tungsten paste, and then sintering is next subjected to grinding or polishing of the substrate surface. Any known grinding or polishing technique can be used as appropriate, but the methods usually employed include lapping, polishing, barrel polishing, sandblasting, and working on a grinder. The surface roughness of the substrate will vary with the intended use, but particularly when a pattern is formed by a thin-film process after polishing, it is preferable for the arithmetical mean roughness (Ra) to be 0.8 $\mu$m or less, and preferably 0.05 $\mu$m or less, because this will increase the adhesive strength between the aluminum nitride and the metallization layer produced by thin-film process.

Cracking of the via portion is a problem encountered when the surface of an aluminum nitride sintered body is ground or polished, but investigation conducted by the inventors has revealed that to prevent cracks in the via portion, the thickness removed by grinding or polishing must be adjusted when a green sheet single layer (one that has not undergone lamination) is sintered and the resulting aluminum nitride sintered body is ground or polished.

To find the cause of cracking, the inventors performed section polishing, observed the pre-sintering via portion by X-ray transmission, and examined whether cracks were already there prior to the sintering, and as a result found that cracks in the via portion are not produced by grinding or polishing, but are actually already present after sintering. Some had already been produced prior to sintering, and some were produced during sintering. Cracks prior to sintering occurred when the type or amount of resin binder in the tungsten paste was inappropriate, or when the viscosity was not suitable, and can therefore be eliminated by adjusting these values to the proper values. A range of about 30,000 to 500,000 P can be used favorably as the viscosity of the paste. Sinkage of the via after filling cannot be avoided when the viscosity is lower than 30,000 P. When the viscosity is over 500,000 P, though, the tungsten paste viscosity is too high for the paste to be completely filled into the through-hole.

The tungsten powder used here is preferably one with an average particle size of 2 to 5 μm, so that the sintering temperatures of the aluminum nitride and tungsten can be brought closer together. A mixture of a plurality of different tungsten particle sizes is often used, in which case it is preferable to use at least 50 wt% tungsten having an average particle size of 2 to 5 μm. If the average particle size of the tungsten powder is less than 2 μm, the sintering commencement temperature of the tungsten will be too low compared to the sintering temperature of the aluminum nitride, so cracks will tend to develop in the tungsten and at the interface between the tungsten and the aluminum nitride. On the other hand, it is also undesirable for the average particle size of the tungsten powder to be larger than 5 μm, because the sinterability of the tungsten will be markedly worse and the tungsten will not be sufficiently sintered at the sintering temperature of the aluminum nitride.

However, even when a suitable tungsten paste is used as discussed above, the surface of the via will be susceptible to scratching in the handling of the green sheet after paste filling, for example. Consequently, cracks and scratches attributable to this handling often occur about 0.01 mm from the surface even after sintering. Meanwhile, there are two causes of the cracks produced during sintering: the difference between the shrinkage factor of the aluminum nitride and the shrinkage factor of the tungsten paste filled in the through-hole, and the difference between the sintering commencement temperature of aluminum nitride and the sintering commencement temperature of tungsten. Of these, the shrinkage factors can be brought closer together by adjusting the filling ratio of the tungsten paste filled in the through-hole, or the density of the aluminum nitride green sheet.

Meanwhile, the sintering commencement temperature of aluminum nitride is between 1700 and 1800 °C, whereas that of tungsten is about 1500 °C. Using tungsten with a coarse particle size is one possible way to bring these temperatures closer together. However, a tungsten powder with an average particle size of at least 5 μm must be used to raise the sintering commencement temperature of tungsten to about 1700 °C, and conversely such a coarse tungsten powder will not completely sinter at the sintering temperature of aluminum nitride, making this method difficult to employ.

One other way is to mix in a substance that hinders the sintering of tungsten. A typical example is to admix an aluminum nitride powder. The aluminum nitride powder mixed into the tungsten powder serves to hinder the sintering of the tungsten up until the aluminum nitride commences sintering, and conversely to promote the sintering of tungsten once the aluminum nitride does commence sintering. Cracks can be minimized with this method as long as the via diameter after sintering is about 0.2 mm.

However, even with a method such as this, the sintering commencement temperatures of the aluminum nitride and of the tungsten paste in the through-hole do not match up exactly, with the sintering commencement temperature of the tungsten paste being lower. Accordingly, while there is no problem when the via diameter is about 0.2 mm, if the via diameter is as large as 0.25 or 0.3 mm, the difference between the sintering commencement temperatures of the aluminum nitride and the tungsten paste becomes a problem, and it is unavoidable that cracks will form. Also, since sintering generally proceeds from the ends and the surface, the sintering of the aluminum nitride also similarly proceeds from the substrate surface. Therefore, cracks attributable to the difference between the sintering commencement temperatures of the aluminum nitride and the tungsten paste tend to occur on the substrate surface.

In view of this, substrate sections were polished and checked to see how far from the substrate surface the cracks had generated, and as a result it was found that the cracks were clustered up to a specific position from the substrate surface. The thickness in which these cracks clustered was one-eighth the substrate thickness from the surface. Accordingly, it was found that to keep cracks from developing in a via when grinding or polishing is performed, the thickness removed by grinding or polishing should be at least one-eighth the substrate thickness for the surface on one side.

Thus, to keep cracks from developing in a via even when grinding or polishing is performed, the thickness removed by grinding or polishing must be at least one-eighth the substrate thickness for the surface on one side, but when a substrate is actually ground or polished, this is performed on both sides. So when an aluminum nitride sintered body obtained by sintering a single green sheet that has not undergone lamination is ground or polished, at least one-eighth must be removed by grinding or polishing on one side, but at least one-fourth (two times one-eighth) on both sides. Meanwhile, when an aluminum nitride sintered body obtained by sintering a plurality of green sheets that have been laminated is ground or polished, just the outermost layer of the various layers of the laminated aluminum nitride sintered body is polished. Also, since just the surface on one side of the outermost layer (of which there are two) is ground or polished, via cracks can be eliminated by removing through grinding or polishing at least one-eighth of a thickness equal to twice the thickness of the outermost layer.

It is even more preferable if the thickness removed by the grinding or polishing of the aluminum nitride sintered body is at least one-fourth the substrate thickness for the surface on one side. As discussed above, it was found that cracks attributable to the difference between the sintering commencement temperatures of the aluminum nitride and the tungsten paste are clustered up to one-eighth of the substrate thickness from the substrate surface, and with a thick substrate the cracks may extend to an even greater depth from the surface. This is particularly pronounced when the substrate thickness after sintering is 0.65 mm or greater. The cause of this seems to be that the greater is the substrate thickness, the greater the temperature differential there tends to be between the substrate surface and the substrate interior, which is related to how readily sintering proceeds at the substrate surface. With a thick substrate such as this, it is preferable to increase the thickness removed by grinding or polishing. Experiments have revealed that if the removed thickness is less than one-fourth of the substrate thickness, cracks may not be completely eradicated. Specifically, when a single green sheet that has not been laminated is sintered and the resulting aluminum nitride sintered body is ground or polished, at least one-fourth is needed to be removed by grinding or polishing on one side, or at least one-half (two times one-fourth) on both sides. Meanwhile, when an aluminum nitride sintered body obtained by sintering a plurality of green sheets that have been laminated is ground or polished, at least one-fourth is removed by grinding or polishing.

It is even more favorable for the thickness removed by grinding or polishing the aluminum nitride sintered body to be at least one-third the substrate thickness for the surface on one side. This is because if the removed thickness is less than one-third, cracks cannot be completely eliminated when the via diameter is large, for example. As mentioned above, there has been a great need in recent years for increasing the via diameter. There is even a need for a via diameter of about 0.4 mm or more after sintering. With a via diameter as large as this, the sinkage and so forth that occur after the tungsten paste is filled into the through-hole cannot be avoided. Also, cracks may develop during sintering, starting at the sinkage produced after filling, and if the thickness removed is less than one-third the substrate thickness, it may be impossible to completely eliminate cracks. Specifically, when an aluminum nitride sintered body obtained by sintering a single green sheet that has not be laminated is ground or polished, it is preferable to remove by grinding or polishing at least one-third on one side and at least two-thirds (two times one-third) on both sides.

Meanwhile, when an aluminum nitride sintered body obtained by laminating and then sintering a plurality of green sheets is ground or polished, at least one-third has to be removed by grinding or polishing. Preferably, the thickness removed by grinding or polishing the aluminum nitride sintered body is no more than two-fifths the substrate thickness for the surface on one side. Specifically, this means that on both sides, no more than four-fifths (two times two-fifths) is removed by grinding or polishing. However, it is also undesirable for the removed thickness to be too great, both in terms of the usage efficiency of the substrate and in terms of the grinding or polishing efficiency, since there will too much waste, leading to higher costs. Furthermore, it is undesirable for the removed thickness to be too great during grinding or polishing because problems such as substrate splitting will tend to occur during grinding or polishing.

After the aluminum nitride sintered body's surface has thus been ground or polished, a conductive pattern is formed as needed by a thick film or thin film process. Any known technique can be used to form the conductive pattern, such as sputtering, vapor deposition, chemical vapor deposition (CVD), ion plating, flame spraying, and screen printing. Of these, when a thin film process is used, the method for forming the conductive pattern can be determined as dictated by the pattern shape. For instance, a metal mask method, wet etching, dry etching, lift-off method, or the like can be used.

The constituent metal that forms the conductive pattern can be any known metal such as titanium, chromium, molybdenum, tungsten, aluminum, tantalum, or Ni-Cr. These metals may be used singly or in combinations of two more types. Furthermore, the conductive pattern may be formed from a single layer, or two or more layers may be laminated.

About three layers are usually laminated when a thin film process such as sputtering or vapor deposition is used. One of the known metals listed above can be used for the first layer in contact with the aluminum nitride, but titanium is usually used because high adhesive strength can be obtained consistently. One of the known metals listed above can also be used for the second layer laminated over the first layer, but when the conductive pattern consists of three or more layers, platinum, nickel, molybdenum, tungsten, palladium, or the like is usually used in order to prevent elements from diffusing between the first and third layers. One of the known metals listed above can also be used for the third layer when one is laminated over the second layer, but platinum, gold, or the like is usually used because of their good electrical conductivity and excellent corrosion resistance. A conductive pattern of nickel, gold, or the like is sometimes laminated by plating or another such method after the laminated conductive pattern of about three layers has been formed by a thin film process.

A resistor pattern for electrically connecting at a certain resistance value may be formed in order to maintain a specific resistance between certain patterns of the conductive pattern. The above-mentioned thin film formation methods and so forth can be used to form the resistor pattern. As to the type of resistor pattern, any known type can be used, but Ta-N, Ni-Cr, or the like is usually used for the sake of achieving stable resistance.

With this resistor pattern, an oxide film is usually formed on the resistor surface in order to suppress temperature changes and changes in the resistance value over time. A known method can be used for this, but anodic oxidation or the like is usually used. Also the resistance is sometimes adjusted. A known method can also be used for this, but laser trimming or the like is usually employed.

As discussed above, the method of the present invention for manufacturing an aluminum nitride substrate that is ground or polished prevents the via cracks that occur after the aluminum nitride substrate surface is ground or polished, even when the via diameter is large.

7 Fourth aspect of the present invention

The fourth aspect of the present invention provides a method for manufacturing an aluminum nitride sintered body having a metallization layer by coating a ceramic green sheet whose main component is aluminum nitride with a paste containing a conductive high-melting point metal, a resin binder, and a solvent, and then sintering the whole thing at once, wherein an amount of the solvent in said paste is 0.5 to 5 weight parts when a combined amount of the metal powder and an inorganic material powder in said paste is 100 weight parts; or

a method for manufacturing an aluminum nitride sintered body having a metallization layer by making a through-hole in a ceramic green sheet whose main component is aluminum nitride, filling said through-hole with a paste containing a conductive high-melting point metal, a resin binder, and a solvent, and then sintering the whole thing at once, wherein an amount of the solvent in said paste is 0.5 to 5 weight parts when a combined amount of the metal powder and an inorganic material powder in said paste is 100 weight parts.

The metallization of aluminum nitride has been considered difficult up to now because of its poor wettability with metals. In view of this, mixing an inorganic material as an adhesion-improving component into a paste has been investigated in an attempt to improve wettability and ensure good adhesive strength with the aluminum nitride after metallization. This inorganic material is usually added in an amount of at least 10 wt%. In terms of volume, this accounts for 30 to 50 vol%, which has greatly hindered attempts at lowering the resistivity per unit of volume of a metallization layer.

Therefore, to achieve the reduction in the resistivity of metallization layers that has recently become so important, the inventors considered it desirable to metallize aluminum nitride without adding any inorganic material, and took a fresh look at the joining mechanism of the aluminum nitride and metal.

As a result, they found that aluminum nitride and a metal are joined by a mechanism involving the interposition of an adhesion-improving component, and by an interlocking mechanism in which the aluminum nitride particles and tungsten particles are mechanically interlocked. They also found that the interlocking mechanism between particles plays a major role in the joining strength of aluminum nitride and a metal. Specifically, they found that it is basically possible for aluminum nitride and a metal to be joined even if no inorganic material (adhesion-improving component) is admixed.

However, to produce metallization with adequate strength without using an adhesion-improving component, the condition of the paste must be strictly controlled. This control is described in detail below, mainly by examining a method in which metallization is produced by co-firing after a paste has been filled into a through-hole provided in a green sheet.

The inventors first investigated the effect of an inorganic material used for adhesion improvement. As a result, they found that changes in the sintering temperature of the metal depending on the inorganic material being mixed into a metal powder has a greater effect on joining than does strengthening the joining of aluminum nitride and a metal by the interposition of the inorganic material itself.

Specifically, the tungsten used as the metal powder has a sintering commencement temperature lower than that of aluminum nitride. For example, if we consider aluminum nitride sintered at 1800 to 1900 °C, the sintering of aluminum nitride commences at 1700 to 1800 °C, whereas the sintering of tungsten commences at 1400 to 1500 °C.

Because the sintering commencement temperatures of aluminum nitride and tungsten are so different, when a paste is filled into a through-hole, for example, shrinkage of the paste portion commences before the sintering (that is, before the shrinkage) of the aluminum nitride matrix commences. Accordingly, cracks tend to develop in weakly bonded portions around the through-hole.

For instance, if there is a heterogeneous portion in the paste filled into the through-hole, cracks will develop inside the via, and if there are defects of some sort in the aluminum nitride matrix, then cracks will develop in the matrix. If there are no defects in either the via or the aluminum nitride, cracks will develop at the interface between the matrix and the via. The occurrence of these cracks is directly linked to a drop in joining strength. Similarly, if we consider a metallization layer printed after via printing, as discussed below, cracks tend to develop around the metallization layer, and there is an attendant decrease in joining strength as well.

In contrast, as discussed above, if an inorganic material (such as aluminum nitride or an inorganic material substantially the same as an aluminum nitride matrix) is added along with the tungsten powder to the paste, the sintering temperature of the tungsten will be brought closer to the sintering temperature of the aluminum nitride, the result being that the aluminum nitride and tungsten will begin shrinking at the same time, so cracks will not develop even if there is a heterogeneous portion in the paste filled into the through-hole, or if there are defects in the aluminum nitride matrix.

This eliminates the decrease in joining strength attributable to cracks.

Thus, the inorganic material serves to bring the sintering temperature of tungsten closer to the sintering temperature of aluminum nitride, but to eliminate the above-mentioned cracks without this inorganic material, any heterogeneous portions in the paste filled into the through-hole or any defects in the aluminum nitride matrix should be eliminated. In view of this, the inventors investigated the process by which these heterogeneous portions in the paste and defects in the matrix are produced. As a result, they concluded that unless there are no defects in the green sheet from the very beginning, heterogeneous portions in the paste and defects in the matrix will occur during the drying of the paste filled in the through-hole.

The mechanism by which heterogeneous portions occur in the paste is as follows. When the paste is filled in the through-hole, the solvent in the paste is absorbed into the green sheet by capillarity as the paste dries naturally. If there is a large amount of absorption into the green sheet here, the movement of solvent into the green sheet will cause the tungsten powder to move into the green sheet at the same time. If the amount of tungsten movement is large, it can end up producing heterogeneous portions that become proto-cracks near the center of the via.

Meanwhile, the mechanism by which defects are generated in the matrix is similar to the generation of heterogeneous portions. Specifically, as mentioned above, when the paste is filled in the through-hole, the solvent is absorbed from the paste into the green sheet by capillarity. If there is a large amount of solvent absorption from the paste, the solvent absorbed into the green sheet will react with the resin component in the green sheet, and the resin component of the green sheet will dissolve in the paste solvent. If the amount of dissolution is considerable, it can lead to defects such as cracks in the matrix.

To prevent these heterogeneous portions in the paste and defects in the matrix, the amount of absorption from the paste into the green sheet must be reduced. The inventors examined various ways to accomplish this, and ascertained that the most important factor is whether the resin component of the green sheet dissolves in the paste solvent.

Specifically, when the solvent of the paste dissolves the resin component of the green sheet, or exhibits compatibility with this resin component, the resin component of the green sheet dissolves by being penetrated by the solvent of the paste, making it more likely that cracks and so forth will form in the green sheet matrix as discussed above. Also, when the resin component of the green sheet thus dissolves and cracks or the like develop in the matrix, this causes even more of the paste solvent to be absorbed into the green sheet, accelerating the absorption from paste to green sheet and making heterogeneous portions of tungsten more apt to occur near the center of the through-hole as discussed above.

Taking these results into account, we would expect that a paste solvent that will not dissolve the resin component of the green sheet should be used in order to prevent heterogeneous portions in the paste and defects in the matrix. On the other hand, however, the paste solvent must dissolve the resin binder or other such resin components of the paste. This is because the resin component must be wetted with the various tungsten powders in the paste, but if the solvent does not dissolve the resin component, the resin component will not be wetted by the tungsten powders.

Also, for the green sheet and paste to be joined properly, the resin component of the green sheet and the resin component of the paste need to exhibit compatibility. If they do not, the paste will simply peel away from the green sheet after drying. Furthermore, it is undesirable for the viscosity and other properties to change while the paste is filled into the through-hole or the like because packability and so forth will also change.

Consequently, the solvent of the paste needs to have a high boiling point (at least 200 °C) so that it will not evaporate during the work of filling it into the through-hole or the like. It is extremely difficult to select a favorable solvent that can satisfy all of these conditions. A solvent having high boiling point that will dissolve the resin component of the paste generally will also end up dissolving the resin component of the green sheet.

Based on these results, it was found that to prevent heterogeneous portions in the paste and defects in the matrix, the amount of solvent in the paste should be controlled so that there will be no movement of tungsten powder during absorption into the green sheet, and so that any solvent absorbed into the green sheet will not dissolve the resin of the green sheet.

The paste is made up of a conductive high-melting point metal, a resin binder, and a solvent. The amount of solvent in the paste is 0.5 to 5 weight parts, when the combined amount of tungsten powder and inorganic material powder in the paste is 100 weight parts. It is undesirable for the solvent content to be less than 0.5 weight part because the solvent will be incapable of sufficiently dissolving the resin binder or other resin component in the paste, and a uniform paste cannot be produced. At this solvent content, the paste will be powdery in places, making screen printing and the like impossible. On the other hand, if the solvent content is over 5 weight parts, the solvent content in the paste will be too high, resulting in movement of the tungsten powder during absorption into the green sheet, or the solvent absorbed into the green sheet cannot be prevented from dissolving the resin of the green sheet.

It is preferable for the solvent content in the paste to be 1 to 3 weight parts. The paste is filled into the through-hole by moving the scraper of a screen printing machine back and forth while pressing the paste with the scraper, but if the solvent content in the paste is less than 1 weight part, as long as it is at least 0.5 weight part as mentioned above, filling will be possible if the pressure on the scraper is raised during filling or the number of filling passes is increased. However, if the pressure is raised during filling, it is very likely that the green sheet will be excessively deformed, which has an adverse effect on dimensional precision and results in warping after sintering. Increasing the number of paste filling passes is also undesirable because it markedly compromises productivity.

Furthermore, with a paste having a solvent content of less than 1 weight part, a uniformly mixed paste cannot be produced unless the mixing time is lengthened or modifications are made to the mixing method during production of the paste. However, modifying the mixing method usually requires an apparatus other than the triple roll mill, pot mill, and so forth listed above, so new installation investment is necessary, resulting in extra costs, and it is therefore preferable not to use these apparatus. Also, lengthening the mixing time lowers productivity, so extended mixing is to be avoided.

On the other hand, if the solvent content is over 3 weight parts, movement of the tungsten powder will occur during stable absorption into the green sheet, or the solvent absorbed into the green sheet cannot be prevented from dissolving the resin of the green sheet. How the solvent is absorbed into the green sheet will vary greatly with the condition of the green sheet, but if the solvent content is over 3 weight parts, the effect thereof will be greater.

With the solvent content controlled as above, it is preferable for the viscosity of the paste at room temperature to be 10,000 to 1,000,000 P. Incidentally, this viscosity will vary slightly from one measurement device to another, but the viscosity values given here were obtained using a 5× HBDV-I+ made by Brookfield. It is undesirable for the viscosity to be less than 10,000 P because the paste will be too soft, so when the green sheet is removed from the screen printing apparatus, for example, the paste that has been filled into the through-hole in screen printing, etc., may run out or adhere to the equipment. On the other hand, it is also undesirable for the viscosity to be over 1,000,000 P because the paste will be too hard, so that the paste cannot be handled properly in screen printing, etc.

The viscosity of the tungsten paste is preferably 30,000 to 500,000 P. If the viscosity is less than 30,000 P, sinkage and the like will occur on the via surface. This is also undesirable because cracks may form in the via under some printing conditions or drying conditions. On the other hand, it is undesirable for the viscosity to be over 500,000 P because although the paste can be handled by a screen printing machine or the like, it will still be extremely hard, so the tungsten paste cannot be completely filled into a via hole by printing under some printing conditions.

As mentioned above, terpineol, butylcarbitol, butylcarbitol acetate, and the like can be used to advantage as the solvent for the paste. A mixture of two or more of these solvents may also be used. Mixing these solvents can give the paste suitable thixotropy and make the paste easier to handle in screen printing and so on.

Also, as mentioned above, the resin binder or other resin component of the paste can be ethyl cellulose, an acrylic resin, or the like. But, since acrylic resins may become excessively stringy during screen printing, the use of ethyl cellulose is preferable. An acrylic resin can still be used, though, by modifying the printing conditions and so forth.

As for the tungsten powder that is used, its average particle size should be 2 to 5 $\mu$m in order to bring the sintering temperatures of the aluminum nitride and tungsten closer together. A plurality of tungsten powders with different average particle sizes are often used as a mixture, in which case it is preferable to use at least 50 wt% tungsten having an average particle size of 2 to 5 $\mu$m. If the average particle size of the tungsten powder is less than 2 pm, the sintering commencement temperature of the tungsten will be too much lower than the sintering temperature of the aluminum nitride, making cracks apt to occur at the tungsten or the interface between the tungsten and aluminum nitride. On the other hand, it is undesirable for the average particle size of the tungsten powder to be greater than 5 $\mu$m because sinterability of the tungsten powder will be markedly worse, and the tungsten will not be sufficiently sintered at the sintering temperature of the aluminum nitride.

As discussed above, the aluminum nitride substrate having a metallization layer of the present invention affords a reduction in the resistivity per unit volume of the metallization layer, while preventing cracking within the metallization layer or in the aluminum nitride, and at the same time affords greater joining strength with aluminum nitride.

## BEST MODE FOR CARRYING OUT THE INVENTION

The present invention will now be described in specific terms through examples.

### Example 1

97 weight parts aluminum nitride powder and 3 weight parts $Y_2O_3$ powder were mixed, to which polyvinylbutyral (used as a resin binder) and dibutyl phthalate (used as a plasticizer) were admixed in amounts of 10 weight parts and 5 weight parts, respectively, and a green sheet with a thickness of 0.5 mm was formed with a doctor blade. This was punched out to a size of 100 × 100 mm with a metal die, after which a through-hole with a diameter of 0.3 mm was formed with a punch.

Meanwhile, a tungsten powder paste was produced by dispersing 100 weight parts tungsten powder and 5 weight parts ethyl cellulose (resin binder) in 3 weight parts butylcarbitol (solvent). Table 1 shows the average particle size of the tungsten powders used.

This paste sample was filled with a screen printing machine into the through-hole of the green sheet obtained above. 5 weight parts butylcarbitol was further mixed into the same paste to lower the viscosity, and circuit printing was performed with a screen printing machine and using a screen of 325 mesh and an emulsion thickness of 20 μm. Two of the printed sheets were then laminated together. This lamination was accomplished by placing one sheet on top of the other in a mold and heating to 50 °C while thermocompressively bonding at a pressure of 10 MPa for 2 minutes in a press. After this, the laminate was degreased in a nitrogen atmosphere at 600 °C, and sintered for 3 hours in a nitrogen atmosphere at 1800 °C.

After sintering, a metallization layer with a thickness of 10 μm had been formed on the printed circuit part of the aluminum nitride sintered body, and the metallization layer had been formed in the through-hole with a diameter of 0.25 mm in the via part. In this state, the sample was checked for cracks in the printed circuit part and the via part under a 40-power microscope.

Next, a nickel plating layer with a thickness of 3 to 5 μm was formed by electroless plating over the metallization layer on the aluminum nitride substrate on which the above metallization layer had been formed. The plating layer was then annealed in an 800 °C forming gas, and then an Fe-Ni-Co alloy pin with a diameter of 0.5 mm and a tensile strength of 500 MPa was soldered on using silver solder. The soldering temperature was 800 °C, and the atmosphere consisted of a mixed gas of hydrogen and nitrogen.

The aluminum nitride substrate was then fixed, the tensile strength of the Fe-Ni-Co alloy pin was measured, and the failure mode was examined. A cross section of the sample was also polished and checked under an electron microscope (1000 power) for cracks in the printed circuit part and the via portion. The particle size of the tungsten after sintering was also checked by electron microscope.

These evaluation results are given in Table 1 along with the paste compositions. No cracks formed in either the printed circuit part or the via portion when the tungsten powder particle size and the sintered tungsten average particle size were within the ranges specified in the present invention. By contrast, in the comparative examples, which were outside the specified ranges of the present invention, cracks were noted in the via, particularly when the sintered tungsten powder had a fine particle size.

As to the tensile strength and failure mode, when the particle size was within the range specified in the present invention, the soldered portion between the Fe-Ni-Co line and the metallization layer fractured at a tensile strength of 20 MPa. This tells us that the joining strength of the aluminum nitride and the metallization layer is at least 20 MPa. On the other hand, with the paste compositions in the comparative examples, the joining strength was lower than 20 MPa, and pastes of low strength broke within the metallization layer directly over the via.

Table 1:

| Results of evaluating average particle size of tungsten before and after sintering | | | | |
|---|---|---|---|---|
| | Tungsten powder average particle size (μm) | Tungsten average particle size after sintering (μm) | Tensile strength (MPa) | Cracks ? |
| Sample 1* | 1.0 | 1.6 | 10 | yes |
| Sample 2* | 1.5 | 1.8 | 13 | yes |
| Sample 3 | 2.0 | 2.2 | 20 | no |
| Sample 4 | 2.5 | 2.7 | 20 | no |
| Sample 5 | 3.0 | 3.3 | 20 | no |
| Sample 6 | 3.5 | 3.7 | 20 | no |
| Sample 7 | 4.0 | 4.2 | 20 | no |
| Sample 8 | 4.5 | 4.7 | 20 | no |
| Sample 9 | 5.0 | 5.2 | 20 | no |
| Sample 10* | 5.5 | 5.6 | 10 | no |
| Sample 11* | 6.0 | 6.2 | 5 | no |
| Asterisk indicates that the sample is a comparative example. | | | | |

**Example 2**

The same experiment as in Example 1 was performed on a different lot of tungsten powder, and the effect that the tungsten powder lot had on tensile strength and cracks in the metallization layer was examined. Ten different tungsten powder lots were used, ten for each average particle size. These lots were subjected to the same evaluations as in Example 1. Table 2 shows the results for the lot with the lowest tensile strength among these.

With samples having a tungsten powder particle size and a post-sintering tungsten average particle size outside the ranges of the present invention, cracks were observed in the vias in those samples having a fine particle size for the tungsten powder and the sintered tungsten. Meanwhile, even with the samples having a tungsten powder particle size and a post-sintering tungsten average particle size within the ranges of the present invention, cracks were observed in the vias in those samples in which the tungsten powder average particle size was less than 3 μm.

As to the tensile strength and failure mode, when the paste composition was outside the ranges specified in the present invention (comparative examples), the joining strength was lower than 20 MPa, and pastes of low strength broke within the metallization layer directly over the via. Meanwhile, even with the tungsten powder particle size and the post-sintering tungsten average particle size of the present invention, when the tungsten powder particle size was less than 3 μm or greater than 4 μm, the joining strength was lower than 20 MPa, and pastes of low strength broke within the metallization layer directly over the via. When the tungsten powder particle size was between 3 and 4 μm, the soldered portion between the Fe-Ni-Co line and the metallization layer fractured at a tensile strength of 20 MPa. This tells us that the joining strength of the aluminum nitride and the metallization layer is at least 20 MPa.

Table 2:

| Results of evaluating average particle size of tungsten before and after sintering | | | | |
|---|---|---|---|---|
| | Tungsten powder average particle size (μm) | Tungsten average particle size after sintering (μm) | Tensile strength (MPa) | Cracks ? |
| Sample 12* | 1.0 | 1.7 | 9 | yes |
| Sample 13* | 1.5 | 1.9 | 11 | yes |
| Sample 14 | 2.0 | 2.3 | 16 | yes |
| Sample 15 | 2.5 | 2.8 | 20 | no |
| Sample 16 | 3.0 | 3.4 | 20 | no |
| Sample 17 | 3.5 | 3.8 | 20 | no |
| Sample 18 | 4.0 | 4.3 | 20 | no |
| Sample 19 | 4.5 | 4.7 | 18 | no |
| Sample 20 | 5.0 | 5.2 | 16 | no |
| Sample 21* | 5.5 | 5.6 | 9 | no |
| Sample 22* | 6.0 | 6.2 | 4 | no |
| Asterisk indicates that the sample is a comparative example. | | | | |

**Example 3**

97 weight parts aluminum nitride powder and 3 weight parts $Y_2O_3$ powder were mixed, to which polyvinylbutyral (used as a resin binder) and dibutyl phthalate (used as a plasticizer) were admixed in amounts of 10 weight parts and 5 weight parts, respectively, and a green sheet with a thickness of 0.5 mm was formed by doctor blade process. This was punched out to a size of 100 × 100 mm with a metal die, after which a through-hole with a diameter of 0.3 mm was formed with a punch.

Meanwhile, a tungsten powder paste was produced by dispersing 100 weight parts tungsten powder and 5 weight parts ethyl cellulose (resin binder) in 3 weight parts butylcarbitol (solvent). A pot mill and a triple roll mill were used for mixing. Table 3 shows the average particle size of the tungsten powders used.

This paste was filled with a screen printing machine into the through-hole. The viscosity of the tungsten pastes was measured using a 5× HBDV-I+ made by Brookfield, and found to be 100,000 P. The tungsten paste powder paste was also weighed before and after being filled into the through-hole, and the filling ratio of the tungsten powder was measured and found to be 44 %.

5 weight parts butylcarbitol was further mixed into the same paste to lower the viscosity, and circuit printing was performed with a screen printing machine and using a screen of 325 mesh and an emulsion thickness of 20 μm. Two of the printed sheets were then laminated together. This lamination was accomplished by placing one sheet on top of the other in a mold and heating to 50 °C while thermocompressively bonding at a pressure of 10 MPa for 2 minutes in a press. After this, the laminate was degreased in a nitrogen atmosphere at 600 °C, and sintered for 3 hours in a nitrogen atmosphere at 1800 °C.

After sintering, a metallization layer with a thickness of 10 pm had been formed on the printed circuit part of the aluminum nitride, and the metallization layer had been formed in the via with a diameter of 0.25 mm in the via part. In this state, the sample was checked for cracks in the printed circuit part and the via part under a 40-power microscope.

A nickel plating layer with a thickness of 3 to 5 μm was formed by electroless plating over the metallization layer on the aluminum nitride substrate on which this metallization layer had been formed. The plating layer was then annealed in an 800 °C forming gas, and then an Fe-Ni-Co alloy pin with a diameter of 0.5 mm and a tensile strength of 500 MPa was soldered on using silver solder. The soldering temperature was 800 °C, and the atmosphere consisted of a mixed gas of hydrogen and nitrogen.

The aluminum nitride substrate was then fixed, the tensile strength of the Fe-Ni-Co alloy pin was measured, and the failure mode was examined. A cross section of the sample was also polished and checked under an electron microscope (1000 power) for cracks in the printed circuit part and the via part. The particle size of the tungsten after sintering was also checked by electron microscope.

These evaluation results are given in Table 3 along with the paste compositions. No cracks formed in either the printed circuit part or the via part when the tungsten powder particle size and the sintered tungsten average particle size were within the ranges specified in the present invention. By contrast, in the comparative examples, cracks were observed in the via, particularly when the sintered tungsten powder had a fine particle size.

As to the tensile strength and failure mode, with samples having the particle size of the present invention, the soldered portion between the Fe-Ni-Co line and the metallization layer fractured at a tensile strength of 20 MPa. This tells us that the joining strength of the aluminum nitride and the metallization layer is at least 20 MPa. On the other hand, with the paste compositions in the comparative examples, the joining strength was lower than 20 MPa, and pastes of low strength broke within the metallization layer directly over the via.

How much inorganic material other than tungsten was contained in the tungsten paste portion after sintering was quantified by sampling the tungsten in the center of the through-hole and analyzing the samples by inductively coupled plasma atomic emission spectrometry. As a result, 0.3 wt% elemental aluminum was detected. The composition in the middle part of the through-hole was also measured by X-ray diffractometer, and as a result $Al_2O_3$ was detected. The $Al_2O_3$ content was calculated from the elemental aluminum content and found to be 0.57 wt%.

Table 3:

| | Tungsten powder average particle size (μm) | Tungsten average particle size after sintering (μm) | Tensile strength (MPa) | Cracks ? |
|---|---|---|---|---|
| Results of evaluating average particle size of tungsten before and after sintering | | | | |
| Sample 23* | 1.0 | 1.5 | 11 | yes |
| Sample 24* | 1.5 | 1.7 | 13 | yes |
| Sample 25 | 2.0 | 2.2 | 20 | no |
| Sample 26 | 2.5 | 2.6 | 20 | no |
| Sample 27 | 3.0 | 3.3 | 20 | no |
| Sample 28 | 3.5 | 3.7 | 20 | no |
| Sample 29 | 4.0 | 4.2 | 20 | no |
| Sample 30 | 4.5 | 4.7 | 20 | no |
| Sample 31 | 5.0 | 5.2 | 20 | no |
| Sample 32* | 5.5 | 5.6 | 12 | no |
| Sample 33* | 6.0 | 6.2 | 5 | no |
| Asterisk indicates that the sample is a comparative example. | | | | |

**Example 4**

The same experiment as in Example 3 was performed on a different lot of tungsten powder, and the effect that the tungsten powder lot had on tensile strength and cracks in the metallization layer was examined. Ten different tungsten powder lots were used, ten for each average particle size. These lots were subjected to the same evaluations as in Example 3. Table 4 shows the results for the lot with the lowest tensile strength among these.

With samples having a tungsten powder particle size and a post-sintering tungsten average particle size outside the ranges of the present invention, cracks were observed in the vias, particularly in those samples having a fine average particle size for the tungsten powder and the sintered tungsten. Meanwhile, even with the samples having a tungsten powder particle size and a post-sintering tungsten average particle size within the ranges of the present invention, cracks were observed in the vias in those samples in which the tungsten powder average particle size was less than 2.5 μm.

As to the tensile strength and failure mode, with the paste compositions of the comparative examples, the joining strength was lower than 20 MPa, and pastes of low strength broke within the metallization layer directly over the via. Meanwhile, even with the tungsten powder particle size and the post-sintering tungsten average particle size of the present invention, when the tungsten powder particle size was less than 2.5 μm or greater than 3.5 μm, the joining strength was lower than 20 MPa, and broke within the metallization layer directly over the via. When the tungsten powder particle size was between 2.5 and 3.5 μm, the soldered portion between the Fe-Ni-Co line and the metallization layer fractured at a tensile strength of 20 MPa. This tells us that the joining strength of the aluminum nitride and the metallization layer is at least 20 MPa.

The amount of inorganic material other than tungsten in the through-hole was measured in the same manner as in Example 3, and as a result 0.55 to 0.64 wt% $Al_2O_3$ was detected.

Table 4:

| | Results of evaluating average particle size of tungsten before and after sintering | | | |
|---|---|---|---|---|
| | Tungsten powder average particle size (μm) | Tungsten average particle size after sintering (μm) | Tensile strength (MPa) | Cracks ? |
| Sample 34* | 1.0 | 1.6 | 8 | yes |
| Sample 35* | 1.5 | 1.8 | 10 | yes |
| Sample 36 | 2.0 | 2.3 | 16 | yes |
| Sample 37 | 2.5 | 2.7 | 20 | no |
| Sample 38 | 3.0 | 3.5 | 20 | no |
| Sample 39 | 3.5 | 3.8 | 20 | no |
| Sample 40 | 4.0 | 4.3 | 20 | no |
| Sample 41 | 4.5 | 4.7 | 18 | no |
| Sample 42 | 5.0 | 5.2 | 16 | no |
| Sample 43* | 5.5 | 5.6 | 10 | no |
| Sample 44* | 6.0 | 6.2 | 4 | no |
| Asterisk indicates that the sample is a comparative example. | | | | |

**Example 5**

Using the same tungsten powder with an average particle size of 2.5 μm as in sample 26 of Example 3, the viscosity of the paste was varied and the effect thereof examined. Table 5 shows the viscosity of the investigated tungsten pastes. The experimental methodology was the same as in Example 3.

The pin tensile strength and cracks in the via part were measured for the various samples in the same manner as in Example 3, the results of which are given in Table 5. When the paste composition was outside the range of the present invention, the joining strength was lower than 20 MPa, and pastes of low strength broke within the metallization layer directly over the via. With sample 45, which was outside the preferred viscosity range, cracks and sinkage were observed in the via, and with sample 54, protrusion of the via and cracks in the aluminum nitride were observed.

Furthermore, sinkage was observed at the via surface with sample 46, in which the viscosity of the tungsten paste was less than 30,000 P and the tungsten powder filling ratio was below 40%. Protrusion of the via was observed with sample 53, in which the viscosity of the tungsten paste was over 500,000 P and the tungsten powder filling ratio over 50%.

Table 5:

| | Paste viscosity, tungsten powder filling ratio, and evaluation results | | | | |
|---|---|---|---|---|---|
| | Paste viscosity (P) | Tungsten powder filling ratio (%) | Tensile strength (MPa) | Via sinkage or protrusion ? | Cracks ? |
| Sample 45 | 8,000 | 25 | 10 | sinkage | yes |
| Sample 46 | 10,000 | 32 | 20 | sinkage | no |
| Sample 47 | 30,000 | 41 | 20 | no | no |
| Sample 48 | 50,000 | 42 | 20 | no | no |
| Sample 49 | 100,000 | 44 | 20 | no | no |
| Sample 50 | 200,000 | 47 | 20 | no | no |
| Sample 51 | 300,000 | 48 | 20 | no | no |
| Sample 52 | 500,000 | 49 | 20 | no | no |
| Sample 53 | 1,000,000 | 68 | 20 | protrusion | no |
| Sample 54 | 1,200,000 | 75 | 4 | protrusion | yes |

## Example 6

The same experiment as in Example 5 was conducted for various samples by increasing the number of green sheets to 100. For each sample, the tungsten powder filling ratio was measured for 100 sheets, and the via cracks were checked immediately after sintering. Table 6 shows the maximum and minimum tungsten paste filling ratios out of the 100 sheets measured. As shown in Table 6, there is variance in the filling ratio of tungsten powder. Furthermore, observation of cracks revealed via cracks in some of the sheets of sample 56, and cracks in the aluminum nitride in some of the sheets of sample 63. The tungsten powder filling ratio was examined for these samples, and as a result, with sample 56, via cracks formed when the tungsten powder filling ratio was less than 30 %. With sample 63, cracks formed in the aluminum nitride when the tungsten powder filling ratio was over 70 %.

Table 6:

| | Paste viscosity, tungsten powder filling ratio, and evaluation results | | |
|---|---|---|---|
| | Paste viscosity (P) | Tungsten powder filling ratio (%) | Cracks? |
| Sample 55 | 8,000 | 22-26 | yes |
| Sample 56 | 10,000 | 29-33 | yes in some |
| Sample 57 | 30,000 | 40-42 | no |
| Sample 58 | 50,000 | 41-43 | no |
| Sample 59 | 100,000 | 42-45 | no |
| Sample 60 | 200,000 | 45-48 | no |
| Sample 61 | 300,000 | 46-49 | no |
| Sample 62 | 500,000 | 48-50 | no |
| Sample 63 | 1,000,000 | 68-71 | yes in some |
| Sample 64 | 1,200,000 | 73-75 | yes |

## Example 7

97 weight parts aluminum nitride powder and 3 weight parts $Y_2O_3$ powder were mixed, to which polyvinylbutyral (used as a resin binder) and dibutyl phthalate (used as a plasticizer) were admixed in amounts of 10 weight parts and 5 weight parts, respectively, and a green sheet with a thickness of 0.5 mm was formed by doctor blade process.

The mixing was performed in two stages, in which the powders and toluene (the solvent) were mixed in a ball mill, after which the resin binder and plasticizer were added and mixed in the ball mill. The mixing time for just this first stage (the powders and solvent) was varied from 1 to 24 hours, and the relative density of the green sheet after being formed with a doctor blade was varied. The green sheets thus produced were punched out to a size of $100 \times 100$ mm with a metal die, after which a through-hole with a diameter of 0.3 mm was formed in each with a punch.

Meanwhile, a tungsten powder paste was produced by dispersing 100 weight parts tungsten powder and 5 weight parts ethyl cellulose (resin binder) in 3 weight parts butylcarbitol (solvent). However, the tungsten powder had an average particle size of 2 μm, and no inorganic material powder was admixed. The viscosity of the tungsten paste was measured using a $5\times$ HBDV-I+ made by Brookfield, and found to be 200,000 P.

Each through-hole was then filled with the above-mentioned tungsten powder paste by screen printing machine, each green sheet filled with tungsten paste was weighed before and after the through-hole was filled with the tungsten paste, and the filling ratio of the tungsten powder was measured and found to be 49 %. In the filling of this tungsten paste into the through-hole by screen printing machine, the paste was rubbed in with a type of scraper called a squeegee, but the tungsten paste was not completely filled into the through-hole unless the squeegee was passed back and forth 4 times.

5 weight parts butylcarbitol was further mixed into the same paste to lower the viscosity, and circuit printing was performed with a screen printing machine and using a screen of 325 mesh and an emulsion thickness of 20 μm. Two of the printed sheets were then laminated together. This lamination was accomplished by placing one sheet on top of the other in a mold and heating to 50 °C while thermocompressively bonding at a pressure of 10 MPa for 2 minutes in a press. After this, the laminate was degreased in a nitrogen atmosphere at 600 °C, and sintered for 3 hours in a nitrogen atmosphere at 1800 °C.

After sintering, a metallization layer with a thickness of 10 μm had been formed on the printed circuit part of the aluminum nitride, and the metallization layer had been formed in the through-hole with a diameter of 0.25 mm in the via part. In this state, the sample was checked for cracks in the printed circuit part and the via part under a 40-power microscope.

A nickel plating layer with a thickness of 3 to 5 μm was formed by electroless plating over the metallization layer on the aluminum nitride substrate on which this metallization layer had been formed. The plating layer was then annealed in an 800 °C forming gas, and then an Fe-Ni-Co alloy pin with a diameter of 0.5 mm and a tensile strength of 500 MPa was soldered on using silver solder. The soldering temperature was 800 °C, and the atmosphere consisted of a mixed gas of hydrogen and nitrogen.

The aluminum nitride substrate was then fixed, the tensile strength of the Fe-Ni-Co alloy pin was measured, and the failure mode was examined. A cross section of the sample was also polished and checked under an electron microscope (1000 power) for cracks in the printed circuit part and the via part. The particle size of the tungsten after sintering was also checked by electron microscope.

These evaluation results are given in Table 7 along with the planar shrinkage factors during sintering of the green sheets. No cracks formed in either the printed circuit part or the via part when the green sheet planar shrinkage factor was within the numerical range specified in the present invention. By contrast, in the comparative examples, cracks were observed in the via when the green sheet planar shrinkage factor was outside the numerical range specified in the present invention.

As to the tensile strength and failure mode, with samples of the present invention, the soldered portion between the Fe-Ni-Co line and the metallization layer fractured at a tensile strength of 20 MPa. This tells us that the joining strength of the aluminum nitride and the metallization layer is at least 20 MPa. On the other hand, with the samples in the comparative examples, the joining strength was lower than 20 MPa, and samples of low strength broke within the metallization layer directly over the via.

Table 7

| Sample No. | Green sheet planar shrinkage factor (%) | Tensile strength (MPa) | Cracks? |
|---|---|---|---|
| Sample 65* | 15.0 | 10 | yes |
| Sample 66 | 16.5 | 20 | no |
| Sample 67 | 18.0 | 20 | no |
| Sample 68 | 20.0 | 20 | no |

Table 7 (continued)

| Sample No. | Green sheet planar shrinkage factor (%) | Tensile strength (MPa) | Cracks? |
|---|---|---|---|
| Sample 69 | 21.0 | 20 | no |
| Asterisk indicates that the sample is a comparative example. | | | |

**Example 8**

The same experiment as in Example 7 was performed by changing the viscosity of the tungsten paste filled into the through-holes to 50,000 P. The viscosity was measured using a 5× HBDV-I+ made by Brookfield. Each green sheet filled with tungsten paste was weighed before and after the through-hole was filled with the tungsten paste, and the filling ratio of the tungsten powder was measured and found to be 40 %. In the filling of this tungsten paste into the through-hole by screen printing machine, the tungsten paste was completely filled into the through-hole after the squeegee was passed back and forth just once.

These evaluation results are given in Table 8 along with the planar shrinkage factors during sintering of the green sheets. No cracks formed in either the printed circuit part or the via part when the green sheet planar shrinkage factor was from 18 to 23 %. On the other hand, when this factor was less than 18 %, cracks were observed in the via. With sample 76, in which the planar shrinkage factor of the green sheet was greater than 23 %, radial cracks developed out from the via in the aluminum nitride sintered body's matrix as well.

As to the tensile strength and failure mode, with samples in which the green sheet planar shrinkage factor was between 18 and 23 %, the soldered portion between the Fe-Ni-Co line and the metallization layer fractured at a tensile strength of 20 MPa. This tells us that the joining strength of the aluminum nitride and the metallization layer is at least 20 MPa. On the other hand, with the samples in which the green sheet planar shrinkage factor was less than 18 % or greater than 23 %, the joining strength was lower than 20 MPa, and samples of low strength broke within the metallization layer directly over the via.

Table 8

| Sample No. | Green sheet planar shrinkage factor (%) | Tensile strength (MPa) | Cracks? |
|---|---|---|---|
| Sample 70* | 15.0 | 10 | yes |
| Sample 71 | 16.5 | 15 | yes |
| Sample 72 | 18.0 | 20 | no |
| Sample 73 | 20.0 | 20 | no |
| Sample 74 | 21.0 | 20 | no |
| Sample 75 | 23.0 | 20 | no |
| Sample 76* | 26.0 | 5 | yes |
| Asterisk indicates that the sample is a comparative example. | | | |

**Example 9**

The same experiment as in Example 8 was conducted, except that the number of green sheets was increased. 100 green sheets were used with each planar shrinkage factor. The same evaluations as in Example 8 were performed, and Table 9 shows the results for the sheet with the lowest tensile strength of these. When the green sheet planar shrinkage factor was between 20 and 23 %, no cracks were produced in either the printed circuit surface or the via part. On the other hand, with a sample in which the planar shrinkage factor was less than 20 %, cracks were observed in the via when this factor was 18 %, at which no cracks were seen in Example 8. With sample 83, in which the green sheet planar shrinkage factor was over 25 %, radial cracks developed out from the via in the aluminum nitride sintered body's matrix as well.

As to the tensile strength and failure mode, with samples in which the green sheet planar shrinkage factor was between 20 and 23 %, the soldered portion between the Fe-Ni-Co line and the metallization layer fractured at a tensile strength of 20 MPa. This tells us that the joining strength of the aluminum nitride and the metallization layer is at least 20 MPa. On the other hand, with the samples in which the green sheet planar shrinkage factor was less than 20 % or greater than 23 %, the joining strength was lower than 20 MPa, and samples of low strength broke within the metallization layer directly over the via.

Also, no cracks were observed in the via in Example 8, but in Example 9, examination of the tungsten filling ratio into the through-hole after via filling with sample 79, whose planar shrinkage factor was 18 %, at which cracks were seen in the via, confirmed this ratio to be less than 40 %.

Table 9

| Sample No. | Green sheet planar shrinkage factor (%) | Tensile strength (MPa) | Cracks? |
|---|---|---|---|
| Sample 77* | 15.0 | 9 | yes |
| Sample 78 | 16.5 | 14 | yes |
| Sample 79 | 18.0 | 18 | yes |
| Sample 80 | 20.0 | 20 | no |
| Sample 81 | 21.0 | 20 | no |
| Sample 82 | 23.0 | 20 | no |
| Sample 83* | 26.0 | 3 | yes |
| Asterisk indicates that the sample is a comparative example. | | | |

## Example 10

The same experiment as in Example 7 was conducted, except that the viscosity of the tungsten paste filled into the through-hole was changed to 10,000 P. The viscosity was measured using a 5× HBDV-I+ made by Brookfield in the same manner as Example 7. Each green sheet filled with tungsten paste was weighed before and after the through-hole was filled with the tungsten paste, and the filling ratio of the tungsten powder was measured and found to be 30 %. In the filling of this tungsten paste into the through-hole by screen printing machine, the tungsten paste was completely filled into the through-hole after the squeegee was passed back and forth just once.

These evaluation results are given in Table 10 along with the planar shrinkage factors during sintering of the green sheets. No cracks formed in either the printed circuit surface or the via part when the green sheet planar shrinkage factor was 25 % or less. On the other hand, with sample 86, in which the planar shrinkage factor of the green sheet was greater than 25 %, radial cracks developed out from the via in the aluminum nitride sintered body's matrix as well.

As to the tensile strength and failure mode, with samples in which the shrinkage factor was 25 % or less, the soldered portion between the Fe-Ni-Co line and the metallization layer fractured at a tensile strength of 20 MPa. This tells us that the joining strength of the aluminum nitride and the metallization layer is at least 20 MPa. On the other hand, with the sample in which the green sheet planar shrinkage factor was greater than 25 %, the joining strength was lower than 20 MPa, and a sample of low strength broke within the metallization layer directly over the via.

Table 10

| Sample No. | Green sheet planar shrinkage factor (%) | Tensile strength (MPa) | Cracks? |
|---|---|---|---|
| Sample 84 | 24.0 | 20 | no |
| Sample 85 | 25.0 | 20 | no |
| Sample 86* | 26.0 | 5 | yes |
| Asterisk indicates that the sample is a comparative example. | | | |

## Example 11

The same experiment as in Example 10 was conducted, except that the number of green sheets was increased. 100 green sheets were used with each planar shrinkage factor. In the filling of the tungsten paste into the through-hole by screen printing machine, the squeegee was passed back and forth once, but with several sheets a depression was observed in the center of the via after filling and drying. The through-hole was filled again with tungsten paste for those samples in which this depression was seen. The same evaluations as in Example 10 were performed, and Table 11 shows the results for the sheet with the lowest tensile strength of these.

No cracks were observed in the via in Example 10, but were found this time in the sample in which the shrinkage factor was 25 %. Samples whose tensile strength decreased compared to that in Example 4 were also examined, and it was found that a sinkage occurred after drying when the tungsten paste was filled into the through-hole the first time. It is believed that via cracks occurred and the tensile strength also decreased because the filling state in the through-hole was worse than that in Example 10.

Table 11

| Sample No. | Green sheet planar shrinkage factor (%) | Tensile strength (MPa) | Cracks? |
|---|---|---|---|
| Sample 87 | 24.0 | 20 | no |
| Sample 88 | 25.0 | 15 | yes |
| Sample 89* | 26.0 | 4 | yes |
| Asterisk indicates that the sample is a comparative example. | | | |

**Example 12**

97 weight parts aluminum nitride powder and 3 weight parts $Y_2O_3$ powder were mixed, to which polyvinylbutyral (used as a resin binder) and dibutyl phthalate (used as a plasticizer) were admixed in amounts of 10 weight parts and 5 weight parts, respectively, and a green sheet with a thickness of 0.5 mm was formed with a doctor blade.

The green sheet thus produced was punched out to a size of $100 \times 100$ mm with a metal die, after which through-holes with a diameter of 0.3 mm were formed with a punch. The number of through-holes per green sheet was 1000.

Meanwhile, a tungsten powder paste was produced by dispersing 100 weight parts tungsten powder and 5 weight parts ethyl cellulose (resin binder) in 3 weight parts butylcarbitol (solvent). However, the tungsten powder had an average particle size of 2 μm, and no inorganic material powder was admixed. The viscosity of the tungsten paste was measured using a $5\times$ HBDV-I+ made by Brookfield, and found to be 200,000 P. Each through-hole was then filled with the above-mentioned tungsten powder paste by screen printing machine. After this, the sheet was degreased in a nitrogen atmosphere at 600 °C, and sintered for 3 hours in a nitrogen atmosphere at 1800 °C.

After sintering, the thickness of the aluminum nitride sintered body was 0.4 mm, and a metallization layer had been formed in the through-hole with a diameter of 0.25 mm in the via part. The sintered aluminum nitride surface was then polished to a mirror finish with a diamond abrasive. This polishing was performed on both sides of the aluminum nitride substrate, and the same thickness was removed by polishing from each side. The Ra of the resulting surface was measured and found to be 0.02 μm.

A 40-power microscope was used to check how the crack generation state in the via part changed, depending on the thickness of the aluminum nitride sintered body, after this mirror finish working. The results are given in Table 12. 10 substrates of the same thickness after mirror finish working were prepared, then the "Probability of via cracks occurring in substrate" in the table indicates the probability of there being a substrate in which even one crack forms in 1000 vias in a single substrate. A substrate free of via cracks could be obtained by polishing away at least one-fourth of the aluminum nitride thickness after sintering and before polishing. Because both sides of the sample were polished evenly, the thickness removed on one side is one-half the numerical value shown in Table 12.

Table 12

| Sample No. | Substrate thickness before polishing (mm) | Substrate thickness after polishing (mm) | Combined thickness removed by polishing on both sides (in parentheses is the ratio to the pre-polishing substrate thickness) (mm) | Probability of via cracks occurring in substrate (%) |
|---|---|---|---|---|
| Sample 90* | 0.4 | 0.32 | 0.08 (1/5) | 100 |
| Sample 91 | 0.4 | 0.30 | 0.10 (1/4) | 0 |
| Sample 92 | 0.4 | 0.20 | 0.20 (1/2) | 0 |
| Sample 93 | 0.4 | 0.13 | 0.27 (2/3) | 0 |
| Asterisk indicates that the sample is a comparative example. | | | | |

**Example 13**

The same experiment as in Example 12 was conducted, except that a green sheet with a thickness of 0.3 mm was used. However, after the tungsten paste was filled into the through-hole, two green sheets were laminated. This lamination was accomplished by placing one sheet on top of the other in a mold and heating to 50 °C while thermocompressively bonding at a pressure of 10 MPa for 2 minutes in a press.

The thickness of the aluminum nitride sintered body after sintering was 0.5 mm. Next, a 40-power microscope was used to check how the crack generation state in the via part changed with the thickness of the aluminum nitride sintered body after mirror finish working, just as in Example 12. The results are given in Table 13. After sintering, a substrate free of via cracks could be obtained by polishing away at least one-eighth of the combined thickness of the outermost layers of the aluminum nitride before polishing. Because both sides of the sample were polished evenly, the thickness removed on one side is one-half the numerical value shown in Table 13.

Table 13

| Sample No. | Substrate thickness before polishing (mm) | Substrate thickness after polishing (mm) | Combined thickness removed by polishing on both sides (in parentheses is the ratio to the pre-polishing substrate thickness) (mm) | Probability of via cracks occurring in substrate (%) |
|---|---|---|---|---|
| Sample 94* | 0.5 | 0.45 | 0.05 (1/10) | 100 |
| Sample 95 | 0.5 | 0.44 | 0.06 (1/8) | 0 |
| Sample 96 | 0.5 | 0.38 | 0.12 (1/4) | 0 |
| Sample 97 | 0.5 | 0.33 | 0.17 (1/3) | 0 |
| Asterisk indicates that the sample is a comparative example. | | | | |

**Example 14**

The same experiment as in Example 12 was conducted, except that a green sheet with a thickness of 0.8 mm was used. No lamination was performed. The thickness of the aluminum nitride sintered body after sintering was 0.66 mm. Next, a 40-power microscope was used to check how the crack generation state in the via part changed, depending on the thickness of the aluminum nitride sintered body, after mirror finish working, just as in Example 12. The results are given in Table 14. After sintering a substrate free of via cracks could be obtained by polishing away at least one-half of the aluminum nitride thickness before polishing. Because both sides of the sample were polished evenly, the thickness removed on one side is one-half the numerical value shown in Table 14.

Table 14

| Sample No. | Substrate thickness before polishing (mm) | Substrate thickness after polishing (mm) | Combined thickness removed by polishing on both sides (in parentheses is the ratio to the pre-polishing substrate thickness) (mm) | Probability of via cracks occurring in substrate (%) |
|---|---|---|---|---|
| Sample 98* | 0.66 | 0.53 | 0.13 (1/5) | 100 |
| Sample 99 | 0.66 | 0.49 | 0.17 (1/4) | 30 |
| Sample 100 | 0.66 | 0.33 | 0.33 (1/2) | 0 |
| Sample 101 | 0.66 | 0.22 | 0.44 (2/3) | 0 |
| Asterisk indicates that the sample is a comparative example. | | | | |

**Example 15**

The same experiment as in Example 13 was conducted, except that a green sheet with a thickness of 0.4 mm was used. Specifically, two sheets were laminated prior to sintering. The thickness of the aluminum nitride sintered body after sintering was 0.66 mm. Next, a 40-power microscope was used to check how the crack generation state in the via part changed with depending on the thickness of the aluminum nitride sintered body after mirror finish working, just as in Example 12. The results are given in Table 15. After sintering, a substrate free of via cracks could be obtained by polishing away at least one-fourth of the combined thickness of the outermost layers of the aluminum nitride before polishing. Because both sides of the sample were polished evenly, the thickness removed on one side is one-half the numerical value shown in Table 15.

Table 15

| Sample No. | Substrate thickness before polishing (mm) | Substrate thickness after polishing (mm) | Combined thickness removed by polishing on both sides (in parentheses is the ratio to the pre-polishing substrate thickness) (mm) | Probability of via cracks occurring in substrate (%) |
|---|---|---|---|---|
| Sample 102* | 0.66 | 0.59 | 0.07 (1/10) | 100 |
| Sample 103 | 0.66 | 0.58 | 0.08 (1/8) | 30 |
| Sample 104 | 0.66 | 0.50 | 0.16 (1/4) | 0 |
| Sample 105 | 0.66 | 0.44 | 0.22 (1/3) | 0 |
| Asterisk indicates that the sample is a comparative example. | | | | |

**Example 16**

The same experiment as in Example 12 was conducted, except that a green sheet with a thickness of 0.5 mm was used. The diameter of the through-hole made in the green sheet was changed to 0.5 mm, and no lamination was performed. The thickness of the aluminum nitride sintered body after sintering was 0.4 mm, and the via diameter produced by filling tungsten into the through-hole was 0.4 mm. Next, a 40-power microscope was used to check how the crack generation state in the via part changed with the thickness of the aluminum nitride sintered body after mirror finish working, just as in Example 12. The results are given in Table 16. A substrate free of via cracks could be obtained by polishing away at least two-thirds of the aluminum nitride thickness after sintering but before polishing. Because both sides of the sample were polished evenly, the thickness removed on one side is one-half the numerical value shown in Table 16.

Table 16

| Sample No. | Substrate thickness before polishing (mm) | Substrate thickness after polishing (mm) | Combined thickness removed by polishing on both sides (in parentheses is the ratio to the pre-polishing substrate thickness) (mm) | Probability of via cracks occurring in substrate (%) |
|---|---|---|---|---|
| Sample 106* | 0.4 | 0.32 | 0.08 (1/5) | 100 |
| Sample 107 | 0.4 | 0.30 | 0.10 (1/4) | 30 |
| Sample 108 | 0.4 | 0.20 | 0.20 (1/2) | 10 |
| Sample 109 | 0.4 | 0.13 | 0.27 (2/3) | 0 |
| Asterisk indicates that the sample is a comparative example. | | | | |

**Example 17**

The same experiment as in Example 13 was conducted, except that a green sheet with a thickness of 0.3 mm was used. Specifically, two sheets were laminated prior to sintering. The diameter of the through-hole made in the green sheet was changed to 0.5 mm. The thickness of the aluminum nitride sintered body after sintering was 0.5 mm, and the via diameter produced by filling tungsten into the through-hole was 0.4 mm. Next, a 40-power microscope was used to check how the crack generation state in the via part changed with the thickness of the aluminum nitride sintered body after mirror finish working, just as in Example 12. The results are given in Table 17. After sintering, a substrate free of via cracks could be obtained by polishing away at least one-third of the combined thickness of the outermost layers of the aluminum nitride before polishing. Because both sides of the sample were polished evenly, the thickness removed on one side is one-half the numerical value shown in Table 17.

Table 17

| Sample No. | Substrate thickness before polishing (mm) | Substrate thickness after polishing (mm) | Combined thickness removed by polishing on both sides (in parentheses is the ratio to the pre-polishing substrate thickness) (mm) | Probability of via cracks occurring in substrate (%) |
|---|---|---|---|---|
| Sample 110* | 0.5 | 0.45 | 0.05 (1/10) | 100 |
| Sample 111 | 0.5 | 0.44 | 0.06 (1/8) | 30 |
| Sample 112 | 0.5 | 0.38 | 0.12 (1/4) | 10 |
| Sample 113 | 0.5 | 0.33 | 0.17 (1/3) | 0 |
| Asterisk indicates that the sample is a comparative example. | | | | |

**Example 18**

Using the same aluminum nitride sintered body as in Example 14, the thickness of the aluminum nitride sintered body removed by polishing was further increased. Just as in Example 14, a 40-power microscope was used to check how the crack generation state in the via part changed with the thickness of the aluminum nitride sintered body after mirror finish working. The results are given in Table 18. No via cracks were observed after polishing. However, with sample 115, in which the combined thickness removed from both sides by polishing was greater than 4/5, a chip was seen at the end of the substrate after polishing. No chip was seen at the substrate end with sample 114.

Table 18

| Sample No. | Substrate thickness before polishing (mm) | Substrate thickness after polishing (mm) | Combined thickness removed by polishing on both sides (in parentheses is the ratio to the pre-polishing substrate thickness) (mm) | Probability of via cracks occurring in substrate (%) |
|---|---|---|---|---|
| Sample 114 | 0.66 | 0.13 | 0.53 (4/5) | 0 |
| Sample 115 | 0.66 | 0.07 | 0.59 (9/10) | 0 |

**Example 19**

97 weight parts aluminum nitride powder and 3 weight parts $Y_2O_3$ powder were mixed, to which polyvinylbutyral (used as a resin binder) and dibutyl phthalate (used as a plasticizer) were admixed in amounts of 10 weight parts and 5 weight parts, respectively, and a green sheet with a thickness of 0.5 mm was formed with a doctor blade. This was punched out to a size of $100 \times 100$ mm with a metal die, after which through-holes with a diameter of 0.4 mm were formed with a punch. The number of through-holes per green sheet was 500.

Meanwhile, a paste was produced by mixing 100 weight parts of a tungsten powder with an average particle size of 2.0 μm, 5 weight parts ethyl cellulose (used as a resin binder), and butylcarbitol (used as a solvent) in the amount given in Table 19. A pot mill and a triple roll mill were used for mixing. The paste thus obtained was filled into the through-holes of the above-mentioned green sheet using a screen printing machine.

Two of the printed sheets were then laminated together. This lamination was accomplished by placing one sheet on top of the other in a mold and heating to 50°C while thermocompressively bonding at a pressure of 10 MPa for 2 minutes in a press. After this, the laminate was degreased in a nitrogen atmosphere at 600 °C, and sintered for 3 hours in a nitrogen atmosphere at 1800 °C.

After sintering, a metallization layer had been formed in the through-holes with a diameter of 0.35 mm in the via part. Then, to check for cracks in the via part, the surface of the sintered aluminum nitride substrate was polished, and the sample was examined at 1000-power with an electron microscope. These evaluation results are given in Table 19 along with the paste compositions. 10 substrates produced under the same conditions were prepared, the "Probability of via cracks occurring in substrate" in the table indicates the probability of there being a substrate in which even one crack forms in 500 vias in a single substrate.

A substrate free of via cracks could be produced by keeping the solvent content in the paste to 5 weight parts or less. When the solvent content in the paste was 0.1 weight part, though, the paste could not be mixed uniformly, and there were pockets of isolated tungsten powder. Also, when this paste was used in screen printing, almost none of the paste was filled into the through-holes.

Also, when the solvent content in the paste was 5 weight parts, via cracks occurred in some of the substrates. When the paste solvent content was 0.5 weight part, the paste was filled into the through-holes by passing the screen printing scraper back and forth 20 times. Incidentally, when the paste solvent content was at least 1 weight part, the paste was filled into the through-holes in four or fewer passes. Printability and productivity are probably not good at a paste solvent content of 0.5 weight part.

Table 19

| Paste sample No. | Paste composition | | | Evaluation results |
|---|---|---|---|---|
| | Tungsten powder (weight parts) | Resin binder (ethyl-cellulose) (weight parts) | Solvent (butyl-carbitol) (weight parts) | Probability of via cracks occurring in substrate |
| Sample 116* | 100 | 5 | 0.1 | - |
| Sample 117 | 100 | 5 | 0.5 | 0 |
| Sample 118 | 100 | 5 | 1 | 0 |
| Sample 119 | 100 | 5 | 2 | 0 |
| Sample 120 | 100 | 5 | 3 | 0 |
| Sample 121 | 100 | 5 | 5 | 30 |
| Sample 122* | 100 | 5 | 7 | 100 |
| Asterisk indicates that the sample is a comparative example. | | | | |

**Example 20**

The same experiment as in Example 19 was conducted, except that terpineol was used as the solvent for the paste. Table 20 shows the paste solvent content and the via crack generation state.

A substrate free of via cracks could be produced by keeping the solvent content in the paste to 5 weight parts or less. When the solvent content in the paste was 0.1 weight part, though, the paste could not be mixed uniformly, and there were pockets of isolated tungsten powder. Also, when this paste was used in screen printing, almost none of the paste was filled into the through-holes.

Also, when the solvent content in the paste was 5 weight parts, via cracks occurred in some of the substrates. When the paste solvent content was 0.5 weight part, the paste was filled into the through-holes by passing the screen printing scraper back and forth 20 times. Incidentally, when the paste solvent content was at least 1 weight part, the paste was filled into the through-holes in four or fewer passes. Printability and productivity are probably not good at a paste solvent content of 0.5 weight part.

Table 20

| Paste sample No. | Paste composition | | | Evaluation results |
|---|---|---|---|---|
| | Tungsten powder (weight parts) | Resin binder (ethyl-cellulose) (weight parts) | Solvent (terpineol) (weight parts) | Probability of via cracks occurring in substrate |
| Sample 123* | 100 | 5 | 0.1 | - |
| Sample 124 | 100 | 5 | 0.5 | 0 |
| Sample 125 | 100 | 5 | 1 | 0 |
| Sample 126 | 100 | 5 | 2 | 0 |
| Sample 127 | 100 | 5 | 3 | 0 |
| Sample 128 | 100 | 5 | 5 | 20 |
| Sample 129* | 100 | 5 | 7 | 100 |
| Asterisk indicates that the sample is a comparative example. | | | | |

**Example 21**

The same green sheet as that used in Example 19 was punched out to a size of 100 × 100 mm with a metal die, after which through-holes with a diameter of 0.4 mm were formed with a punch.

Meanwhile, a tungsten paste was produced by dispersing 100 weight parts tungsten powder with an average particle size of 2 μm and 5 weight parts ethyl cellulose (resin binder) in 3 weight parts butylcarbitol (solvent). A pot mill and a triple roll mill were used for mixing. The tungsten paste thus obtained was filled into the above-mentioned through-holes (sample 130).

Pastes were also produced by dispersing 100 weight parts of a mixture containing a tungsten powder with an average particle size of 2.0 μm and an aluminum nitride powder with an average particle size of 1.0 μm in a ratio of 85:15 (sample 131), 70:30 (sample 132), or 60:40 (sample 133) and 5 weight parts ethyl cellulose in 3 weight parts butylcarbitol, and these pastes were filled into through-holes.

After this, two printed sheets were laminated in the same manner as in Example 19, the laminate was degreased in a nitrogen atmosphere at 600 °C, and sintered for 3 hours in a nitrogen atmosphere at 1800 °C. After sintering, a metallization layer had been formed in the via with a diameter of 0.35 mm in the via part of the aluminum nitride. A tester was used to measure the conductivity between the top and bottom sides of the via for these samples, and the electrical resistance of the via was measured. These measurement results are given in Table 21.

Table 21

| Paste sample No. | Paste composition | | | | Evaluation results |
|---|---|---|---|---|---|
| | Tungsten powder (weight parts) | AlN powder (weight parts) | Resin binder (ethyl-cellulose) (weight parts) | Solvent (butyl-carbitol) (weight parts) | Via electrical resistance (mΩ) |
| Sample 130 | 100 | 0 | 5 | 3 | 1.8 |
| Sample 131 | 85 | 15 | 5 | 3 | 2.9 |
| Sample 132 | 70 | 30 | 5 | 3 | 4.9 |
| Sample 133 | 60 | 40 | 5 | 3 | 20.1 |

To check for cracks in the via part, the surface of the sintered aluminum nitride substrate was polished, and each sample was examined at 1000-power with an electron microscope, but no cracks had developed in any of the samples. Also, as shown in Table 21, with samples in which the added amount of inorganic material powder was kept low had much lower electrical resistance in the metallization layer than in the vias obtained by admixing an inorganic material powder.

**INDUSTRIAL APPLICABILITY**

With the present invention, in a metallization layer mainly composed of a conductive high-melting point metal and formed on an aluminum nitride, tungsten, whose coefficient of thermal expansion is close to that of aluminum nitride, is selected as the conductive high-melting point metal, and the average particle size of the tungsten powder is kept to between 2 and 5 μm, and preferably between 2.5 and 4 μm, which allows cracks to be prevented and the adhesive strength with aluminum nitride to be increased even when the metallization layer is as thick as about 0.1 mm or a metal layer is formed in a through-hole. Accordingly, aluminum nitride can be used to advantage in IC substrates and packages. Furthermore, by not admixing an inorganic material (an adhesion-improving component), the resistivity per unit volume of the metallization layer is decreased, no cracks formed in the metallization layer, and a metallization layer with high adhesive strength with the aluminum nitride can be formed. As a result, this aluminum nitride can be used favorably in applications that require low resistivity, such as high-frequency IC substrate and package materials.

Also, with the present invention, tungsten, whose coefficient of thermal expansion is close to that of aluminum nitride, is selected as the conductive high-melting point metal of a paste used to form a metallization layer, and the planar shrinkage factor of a green sheet of aluminum nitride during sintering is set to between 16.5 and 25 %, and preferably between 18 and 23 %, and even more preferably between 20 and 23 %, which allows cracks to be prevented and the adhesive strength with aluminum nitride to be increased in the formation of a metal layer even when the metallization layer is as thick as about 0.1 mm or a via diameter is as great as 0.3 mm or more. Accordingly, the aluminum nitride sintered body of the present invention can be used favorably as IC substrate and package materials.

Also, with the present invention, in an aluminum nitride sintered body used as a substrate after surface grinding or polishing, with a single-layer structure obtained by sintering without lamination, the thickness removed by grinding or polishing is at least one-fourth, and preferably at least one-half, the thickness of the aluminum nitride sintered body, or with a structure obtained by sintering after lamination, the removed thickness is at least one-eighth, and preferably at least one-fourth, a thickness equal to twice the thickness of the outermost layer, and as a result, the via cracks that occur after grinding or polishing can be prevented even when the via diameter is as great as 0.25 to 0.4 mm after sintering. Accordingly, aluminum nitride can be used favorable IC substrate and package materials.

Also, with the present invention, the solvent content in the paste is kept to between 0.5 and 5 weight parts, and preferably between 1 and 3 weight parts, and as a result, cracks are prevented from going into the metallization layer or the aluminum nitride sintered body's matrix, and high adhesive strength can be obtained between the metallization layer and the aluminum nitride, even if no inorganic material or the like is admixed into the metal powder paste. Accordingly, the aluminum nitride sintered body of the present invention can be used favorably in applications that require low resistivity, such as high-frequency IC substrates and packages.

**Claims**

1.  An aluminum nitride sintered body having a metallization layer on its surface and/or in its interior, wherein the metallization layer is composed primarily of a conductive high-melting point metal, the conductive high-melting point metal is tungsten, and an average particle size of the tungsten is 2 to 5.5 μm.

2.  An aluminum nitride sintered body having a metallization layer according to Claim 1, wherein the average particle size of the tungsten is 2.5 to 4.5 μm.

3.  An aluminum nitride sintered body having a metallization layer according to Claim 1 or 2, wherein the metallization layer contains an inorganic material, and the inorganic material is 1 wt% or less.

4.  A method for manufacturing an aluminum nitride sintered body having a metallization layer by coating a ceramic green sheet whose main component is aluminum nitride with a paste mainly containing a conductive high-melting point metal, and then sintering the whole thing at once, wherein the conductive high-melting point metal contained in the paste is a tungsten powder with an average particle size of 2 to 5 μm.

5.  An method for manufacturing an aluminum nitride sintered body having a metallization layer according to Claim 4, wherein the average particle size of the tungsten powder is 2.5 to 4 μm.

6.  An method for manufacturing an aluminum nitride sintered body having a metallization layer according to Claim 4 or 5, wherein no inorganic material powder other than tungsten is mixed into the paste.

7.  A method for manufacturing an aluminum nitride sintered body having a metallization layer by making a through-hole in a ceramic green sheet whose main component is aluminum nitride, filling said through-hole with a paste mainly containing a conductive high-melting point metal, and then sintering the whole thing at once, wherein the conductive high-melting point metal contained in the paste is a tungsten powder with an average particle size of 2 to 5 µm.

8. A method for manufacturing an aluminum nitride sintered body having a metallization layer according to Claim 7, wherein the average particle size of the tungsten powder is 2.5 to 4 µm.

9. A method for manufacturing an aluminum nitride sintered body having a metallization layer according to Claim 7 or 8, wherein no inorganic material powder other than tungsten is mixed into the paste.

10. A method for manufacturing an aluminum nitride sintered body having a metallization layer according to any of Claims 7 to 9, wherein a viscosity of the paste is between 10,000 and 1,000,000 P.

11. A method for manufacturing an aluminum nitride sintered body having a metallization layer according to Claim 10, wherein the viscosity of the paste is between 30,000 and 500,000 P.

12. A method for manufacturing an aluminum nitride sintered body having a metallization layer according to any of Claims 9 to 11, wherein, when filling the through-hole with the paste, a filling ratio of the tungsten powder in the through-hole is 30 to 70 %.

13. A method for manufacturing an aluminum nitride sintered body having a metallization layer according to Claim 12, wherein the filling ratio is 40 to 50 %.

14. A method for manufacturing an aluminum nitride sintered body having a metallization layer by coating a ceramic green sheet whose main component is aluminum nitride with a paste containing a conductive high-melting point metal, and then sintering the whole thing at once, wherein the conductive high-melting point metal contained in the paste is tungsten, and a planar shrinkage factor when the ceramic green sheet is sintered is 16.5 to 25 %.

15. A method for manufacturing an aluminum nitride sintered body having a metallization layer according to Claim 14, wherein the planar shrinkage factor when the ceramic green sheet is sintered is 18 to 23 %.

16. A method for manufacturing an aluminum nitride sintered body having a metallization layer according to Claim 15, wherein the planar shrinkage factor when the ceramic green sheet is sintered is 20 to 23 %.

17. A method for manufacturing an aluminum nitride sintered body having a metallization layer by making a through-hole in a ceramic green sheet whose main component is aluminum nitride, filling said through-hole with a paste containing a conductive high-melting point metal, and then sintering the whole thing at once, wherein the conductive high-melting point metal contained in the paste is tungsten, and a planar shrinkage factor when the ceramic green sheet is sintered is 16.5 to 25 %.

18. A method for manufacturing an aluminum nitride sintered body having a metallization layer according to Claim 17, wherein the planar shrinkage factor when the ceramic green sheet is sintered is 18 to 23 %.

19. A method for manufacturing an aluminum nitride sintered body having a metallization layer according to Claim 18, wherein the planar shrinkage factor when the ceramic green sheet is sintered is 20 to 23 %.

20. A method for manufacturing an aluminum nitride sintered body substrate which is used as a substrate after surface grinding or polishing and has at least one via that is a metallized conductor for electrically connecting upper and lower surfaces, wherein a through-hole is made in a ceramic green sheet whose main component is aluminum nitride, said through-hole is filled with a paste containing a conductive high-melting point metal, the entire single-layer green sheet thus obtained is sintered all at once without being laminated, thereby obtaining an aluminum nitride sintered body, and the surface of this aluminum nitride sintered body is then ground or polished so as to remove at least one-fourth of the thickness of said aluminum nitride sintered body.

21. A method for manufacturing an aluminum nitride sintered body substrate according to Claim 20, wherein the thickness removed by grinding or polishing is at least one-half of the thickness of the aluminum nitride sintered body.

**22.** A method for manufacturing an aluminum nitride sintered body substrate according to Claim 20 or 21, wherein a main component of the via is tungsten.

**23.** A method for manufacturing an aluminum nitride sinter substrate which is used as a substrate after surface grinding or polishing and has at least one via that is a metallized conductor for electrically connecting upper and lower surfaces, wherein a through-hole is made in a ceramic green sheet whose main component is aluminum nitride, said through-hole is filled with a paste containing a conductive high-melting point metal, a plurality of the entire single-layer green sheets thus obtained are laminated and sintered all at once, thereby obtaining an aluminum nitride sintered body, and the surface of this aluminum nitride sintered body is then ground or polished to remove at least one-eighth of a thickness equal to twice a thickness of an outermost layer of the layers constituting said aluminum nitride sintered body.

**24.** A method for manufacturing an aluminum nitride sintered body substrate according to Claim 23, wherein the thickness removed by grinding or polishing is at least one-fourth of a thickness equal to twice the thickness of the outermost layer of the layers constituting said aluminum nitride sintered body.

**25.** A method for manufacturing an aluminum nitride sintered body substrate according to Claim 23 or 24, wherein the main component of the via is tungsten.

**26.** A method for manufacturing an aluminum nitride sintered body having a metallization layer by coating a ceramic green sheet whose main component is aluminum nitride with a paste containing a conductive high-melting point metal, a resin binder, and a solvent, and then sintering the whole thing at once, wherein an amount of the solvent in said paste is 0.5 to 5 weight parts when a combined amount of the metal powder and an inorganic material powder in said paste is 100 weight parts.

**27.** A method for manufacturing an aluminum nitride sintered body having a metallization layer by making a through-hole in a ceramic green sheet whose main component is aluminum nitride, filling said through-hole with a paste containing a conductive high-melting point metal, a resin binder, and a solvent, and then sintering the whole thing at once, wherein an amount of the solvent in said paste is 0.5 to 5 weight parts when a combined amount of the metal powder and an inorganic material powder in said paste is 100 weight parts.

**28.** A method for manufacturing an aluminum nitride sintered body having a metallization layer according to Claim 26 or 27, wherein the conductive high-melting point metal contained in the paste is tungsten.

**29.** A method for manufacturing an aluminum nitride sintered body having a metallization layer according to any of Claims 26 to 28, wherein the paste contains at least one solvent selected from terpineol, butylcarbitol, and butyl-carbitol acetate.

**30.** A method for manufacturing an aluminum nitride sintered body having a metallization layer according to any of Claims 26 to 29, wherein the amount of solvent in the paste is 1 to 3 weight parts when the combined amount of the metal powder and an inorganic material powder in the paste is 100 weight parts.

**31.** A method for manufacturing an aluminum nitride sintered body having a metallization layer according to any of Claims 26 to 30, wherein the resin binder is ethylcellulose.

# EP 1 509 071 A1

<table>
<tr><td colspan="2" style="text-align:center">**INTERNATIONAL SEARCH REPORT**</td><td>International application No.<br>PCT/JP03/06362</td></tr>
</table>

**A. CLASSIFICATION OF SUBJECT MATTER**
Int.Cl$^7$ H05K3/46, 1/09, 1/11, 3/40

According to International Patent Classification (IPC) or to both national classification and IPC

**B. FIELDS SEARCHED**

Minimum documentation searched (classification system followed by classification symbols)
Int.Cl$^7$ H05K3/46, 1/09, 1/11, 3/40

Documentation searched other than minimum documentation to the extent that such documents are included in the fields searched

| | | | |
|---|---|---|---|
| Jitsuyo Shinan Koho | 1926–1996 | Jitsuyo Shinan Toroku Koho | 1996–2003 |
| Kokai Jitsuyo Shinan Koho | 1971–2003 | Toroku Jitsuyo Shinan Koho | 1994–2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 8-97528 A (Toshiba Corp.),<br>12 April, 1996 (12.04.96),<br>(Family: none) | 1–13 |
| Y | JP 9-199851 A (Sumitomo Metal (SMI) Electronics Devices Inc.),<br>31 July, 1997 (31.07.97),<br>(Family: none) | 1–13 |
| Y | JP 3-229489 A (Ibiden Co., Ltd.),<br>11 October, 1991 (11.10.91),<br>(Family: none) | 10–13 |
| Y | JP 3-212991 A (Fujitsu Ltd.),<br>18 September, 1991 (18.09.91),<br>(Family: none) | 12–13 |

☒ Further documents are listed in the continuation of Box C.　　☐ See patent family annex.

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>13 August, 2003 (13.08.03) | Date of mailing of the international search report<br>26 August, 2003 (26.08.03) |
| Name and mailing address of the ISA/<br>Japanese Patent Office | Authorized officer |
| Facsimile No. | Telephone No. |

Form PCT/ISA/210 (second sheet) (July 1998)

## INTERNATIONAL SEARCH REPORT

International application No.

PCT/JP03/06362

C (Continuation). DOCUMENTS CONSIDERED TO BE RELEVANT

| Category* | Citation of document, with indication, where appropriate, of the relevant passages | Relevant to claim No. |
|---|---|---|
| Y | JP 7-74469 A (Ibiden Co., Ltd.), 17 March, 1995 (17.03.95), (Family: none) | 14-19 |
| Y | JP 56-15159 B2 (International Business Machines Corp.), 08 April, 1981 (08.04.81), & DE 2703956 A1 & FR 2340288 A & US 4109377 A & GB 1565421 A & CA 1078079 A | 14-19 |
| Y A | JP 6-13755 A (Hitachi, Ltd.), 21 January, 1994 (21.01.94), (Family: none) | 23-25 20-22 |
| Y A | JP 6-211586 A (NGK Spark Plug Co., Ltd.), 02 August, 1994 (02.08.94), (Family: none) | 23-25 20-22 |
| X | JP 10-279377 A (Tokuyama Corp.), 20 October, 1998 (20.10.98), (Family: none) | 26-31 |

Form PCT/ISA/210 (continuation of second sheet) (July 1998)

## INTERNATIONAL SEARCH REPORT

| International application No. |
| --- |
| PCT/JP03/06362 |

**Box I    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box II    Observations where unity of invention is lacking (Continuation of item 3 of first sheet)**

This International Searching Authority found multiple inventions in this international application, as follows:

(see extra sheet)

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**    ☐    The additional search fees were accompanied by the applicant's protest.

☒    ·No protest accompanied the payment of additional search fees.

Form PCT/ISA/210 (continuation of first sheet (1)) (July 1998)

| **INTERNATIONAL SEARCH REPORT** | International application No. |
|---|---|
| | PCT/JP03/06362 |

Continuation of Box No.II of continuation of first sheet(1)

The matter in claims 1 to 13 that "an electroconductive metal having a high melting point contained in a metallized layer has an average particle diameter of 2 to 5 μm" relates to "to allow the sintering starting temperature of aluminum nitride to approach that of W and not to adversely affect on the sintering characteristics of a W powder",

the matter in claims 14 to 19 that "the shrinkage percentage of a ceramic green sheet in the plane direction during sintering is 16.5 to 25 %" relates to "to control the shrinkage percentage of an aluminum nitride base material so as to approach to that of W",

the matter in claims 20 to 25 that "the surface of an aluminum nitride sintered compact is ground or polished so that 1/4 or more of the thickness of said aluminum nitride sintered compact is removed" relates to "to remove cracks by grinding or polishing the material corresponding to a thickness wherein cracks are concentrated", and

the matter in claims 26 to 31 that "the amount of a solvent in a paste is 0.5 to 5 parts by weight relative to 100 parts by weight of the sum of a metal powder and an inorganic material powder in said paste" relates to "to control the amount of a solvent in a paste so as for a W powder not to transfer when it is absorbed into a green sheet and so as for a solvent absorbed into a green sheet not to dissolve the resin in the green sheet".

There is no technical relationship between these inventions involving one or more of the same or corresponding special technical features, and therefore, these inventions are not so linked as to form a single general inventive concept.

Form PCT/ISA/210 (extra sheet) (July 1998)